(19) Europäisches Patentamt
European Patent Office
Office européen des brevets

(11) **EP 1 382 565 B1**

(12) **EUROPEAN PATENT SPECIFICATION**

(45) Date of publication and mention
of the grant of the patent:
**29.12.2010 Bulletin 2010/52**

(51) Int Cl.:
***B81C 1/00*** *(2006.01)*     ***H01L 21/302*** *(2006.01)*
***H01L 21/00*** *(2006.01)*     ***B81B 3/00*** *(2006.01)*

(21) Application number: **02707133.1**

(22) Date of filing: **22.03.2002**

(86) International application number:
**PCT/JP2002/002807**

(87) International publication number:
**WO 2002/079080 (10.10.2002 Gazette 2002/41)**

(54) **A METHOD OF FORMING A HOLLOW STRUCTURE FROM A SILICON STRUCTURE**

EIN VERFAHREN ZUM ERZEUGEN EINER HOHLEN STRUKTUR AUS EINER SILIZIUM-STRUKTUR

PROCEDE DE PRODUCTION D'UNE STRUCTURE CREUSE A PARTIR D'UNE STRUCTURE DE SILICIUM

(84) Designated Contracting States:
**AT BE CH CY DE DK ES FI FR GB GR IE IT LI LU MC NL PT SE TR**

(30) Priority: **29.03.2001 JP 2001096077**

(43) Date of publication of application:
**21.01.2004 Bulletin 2004/04**

(73) Proprietor: **KABUSHIKI KAISHA TOYOTA CHUO KENKYUSHO**
**Aichi-gun,**
**Aichi-ken, 480-1192 (JP)**

(72) Inventors:
• **Shimaoka, Keiichi,**
**KK Toyota Chuo Kenyko**
**Aichi-gun, Aichi 480-1192 (JP)**
• **Sakata, Jiro,**
**KK Toyota Chuo Kenkyo**
**Aichi-gun, Aichi 480-1192 (JP)**
• **Mizuno Takanori,**
**KK Toyota Chuo Kenkyo**
**Aichi-gun, Aichi 480-1192 (JP)**
• **Okuda, Katsuharu,**
**KK Toyota Chuo Kenkyo**
**Aichi-gun, Aichi 480-1192 (JP)**
• **Matsui, Masayuki,**
**KK Toyota Chuo Kenkyusho**
**Aichi-gun, Aichi 480-1192 (JP)**
• **Suzuki, Yasuhiko,**
**KK Toyota Chuo Kenkyusho**
**Aichi-gun, Aichi 480-1192 (JP)**

(74) Representative: **Kramer - Barske - Schmidtchen**
**European Patent Attorneys**
**Landsberger Strasse 300**
**80687 München (DE)**

(56) References cited:
WO-A1-87/01508     JP-A- 2 187 025
JP-A- 2 207 524     JP-A- 3 127 830
JP-A- 10 209 088     JP-A- 10 242 132
JP-A- 11 274 142     JP-A- 11 288 929
JP-A- 58 130 531     JP-A- 62 031 124
JP-B1- 38 025 061     US-A- 4 190 488
US-A- 4 670 126     US-A- 5 013 398
US-A- 5 271 799     US-A- 5 286 344
US-A- 5 876 497     US-A- 6 162 367

• LANGLEY R C ET AL: "One-chamber polycide sandwich etching" SEMICONDUCTOR INTERNATIONAL, vol. 12, no. 11, October 1989 (1989-10), pages 95-97, XP009050299 USA ISSN: 0163-3767
• WILLIAMS K R ET AL: "ETCH RATES FOR MICROMACHINING PROCESSING" JOURNAL OF MICROELECTROMECHANICAL SYSTEMS, vol. 5, no. 4, December 1996 (1996-12), pages 256-269, XP000678680 NEW YORK, US ISSN: 1057-7157

- TSUCHIYA T ET AL: "Tensile test of bulk- and surface-micromachined 0.1-[mu]m thick silicon film using electrostatic force grip system" MATERIALS SCIENCE OF MICROELECTROMECHANICAL SYSTEMS (MEMS) DEVICES IV. SYMPOSIUM (MATERIALS RESEARCH SOCIETY SYMPOSIUM PROCEEDINGS VOL.687) MATER. RES. SOC, 25 November 2001 (2001-11-25), pages 203-208, XP009050248 WARRENDALE, PA, USA ISBN: 1-55899-623-0
- WERKHOVEN C J ET AL: "Process control improvements realized in a vertical reactor cluster tool" PROCEEDINGS OF THE SPIE, ADVANCED TECHNIQUES FOR INTEGRATED CIRCUIT PROCESSING II, 21-23 SEPT. 1992, SAN JOSE, CA, USA, vol. 1803, 1993, pages 332-344, XP002344147 USA ISSN: 0277-786X
- PATENT ABSTRACTS OF JAPAN vol. 2000, no. 01, 31 January 2000 (2000-01-31) -& JP 11 288929 A (TOYOTA CENTRAL RES & DEV LAB INC), 19 October 1999 (1999-10-19)
- PATENT ABSTRACTS OF JAPAN vol. 1996, no. 11, 29 November 1996 (1996-11-29) -& JP 08 195381 A (FUJITSU LTD), 30 July 1996 (1996-07-30)
- PATENT ABSTRACTS OF JAPAN vol. 1998, no. 13, 30 November 1998 (1998-11-30) -& JP 10 209088 A (MITSUBISHI ELECTRIC CORP), 7 August 1998 (1998-08-07)
- WON ICK JANG ET AL: "Fabrication of surface-micromachined thermally driven micropump by anhydrous HF gas-phase etching with 2-Propanol" PROCEEDINGS OF THE SPIE, MICROMACHINING AND MICROFABRICATION PROCESS TECHNOLOGY VI, 18-20 SEPT. 2000, SANTA CLARA, CA, USA, vol. 4174, 18 September 2000 (2000-09-18), pages 444-450, XP009015808 SPIE, BELLINGHAM, VA, US ISSN: 0277-786X
- CHANG F I ET AL: "GAS-PHASE SILICON MICROMACHINING WITH XENON DIFLUORIDE" PROCEEDINGS OF THE SPIE, MICROELECTRONIC STRUCTURES AND MICROELECTROMECHANICAL DEVICES FOR OPTICAL PROCESSING AND MULTIMEDIA APPLICATIONS, 24 OCT. 1995, AUSTIN, TX, USA, vol. 2641, 24 October 1995 (1995-10-24), pages 117-128, XP001145944 SPIE, BELLINGHAM, VA, US ISSN: 0277-786X
- WITVROUW A ET AL: "Comparison between wet HF etching and vapor HF etching for sacrificial oxide removal" PROCEEDINGS OF THE SPIE, MICROMACHINING AND MICROFABRICATION PROCESS TECHNOLOGY VI, 18-20 SEPT. 2000, SANTA CLARA, CA, USA, vol. 4174, 2000, pages 130-141, XP002344148 USA ISSN: 0277-786X

**Description**

FIELD OF THE INVENTION

The present invention relates to a processing technique for silicon material and a manufacturing technique for a silicon structure. The silicon material of the present specification is monocrystal silicon, polycrystal silicon, silicon oxide, silicon nitride, etc. The silicon structure is a structure wherein silicon material is incorporated during or after manufacture. Materials other than the silicon material may also be incorporated in the silicon structure.

BACKGROUND OF THE INVENTION

A variety of processing techniques for silicon material have been developed as a variety of techniques for manufacturing semiconductors have advanced. The utilization of these silicon material processing techniques allows the manufacture not only of semiconductors such as MOS (Metal Oxide Semiconductors) etc., but also of a variety of silicon structures that function as sensors, actuators, etc. At present, it is possible to perform detailed processing of silicon material with dimensions measured in $\mu$m or less, these detailed processing techniques (micromachining techniques) allowing the manufacture of a microstructure to the order of $\mu$m.

(FIRST BACKGROUND TO THE INVENTION)

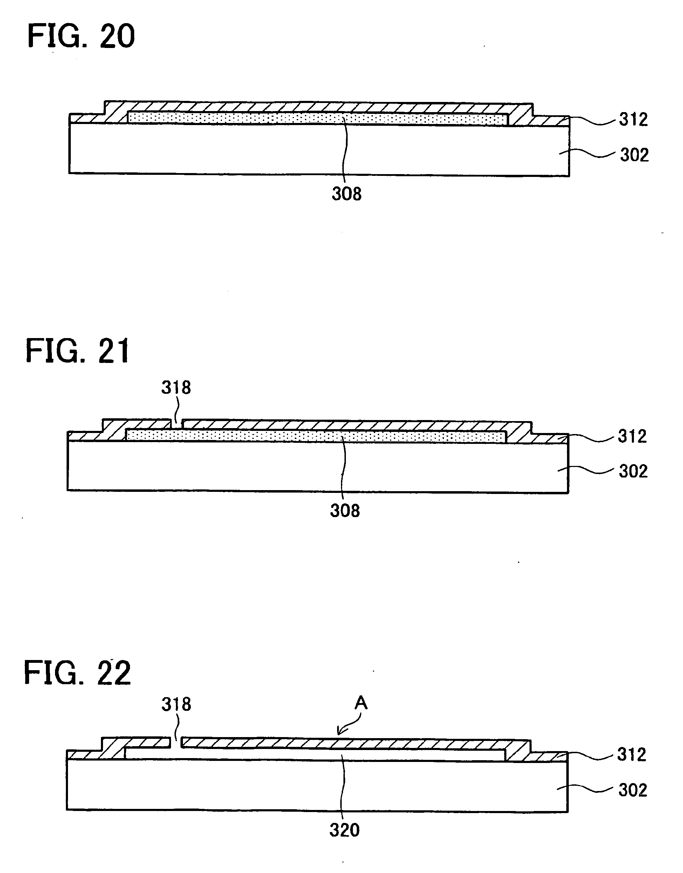

Described next with reference to FIGS. 20 to 22 is an example of manufacturing method utilizing a silicon material processing technique, whereby a silicon structure having a hollow space 320 (shown in FIG. 22) is manufactured. This silicon structure has a beam or mass A extending above the hollow space 320.
First, as shown in FIG. 20, a silicon oxide layer 308 is formed along a prescribed area above a silicon substrate 302. Next, a silicon layer 312 is formed so as to cover the silicon oxide layer 308.
The silicon structure shown in FIG. 20, obtained via the process described above, is housed within an etching reaction chamber of a dry etching device. This device supplies gas that etches the silicon into the etching reaction chamber, locally dry etching the silicon layer 312, as shown in FIG. 21. By this means, an etching hole 318 is formed that extends to the silicon oxide layer 308. As a result, a portion of the silicon oxide layer 308 is exposed.
The silicon structure shown in FIG. 21, wherein the etching hole 318 has been formed, is now housed within an etching vessel of a wet etching device, and is immersed in etchant. This etchant may, for example, be a diluted solution of hydrofluoric acid (dilute HF). Hydrogen fluoride solution etches silicon oxide, but barely etches silicon. As a result, as shown in FIG. 22, the silicon oxide layer 308 is removed by the wet etching. The silicon oxide layer 308 is a layer whose purpose is to finally be removed so as to produce the hollow space 320. This layer is usually termed the 'sacrificial layer'. By this means, a hollow silicon structure having the hollow space 320 is manufactured.
This structure may, for example, be utilized as an acceleration sensor. When it is utilized as an acceleration sensor, a portion A of the silicon layer 312 is used as a beam or mass that moves when acceleration occurs. For example, when acceleration occurs in a direction perpendicular to a substrate face of the silicon substrate 302, the mass A moves in a direction perpendicular to the substrate face. The movement of the mass A is sensed by means of sensing a change in the electrostatic capacity between electrodes (not shown), this allowing the acceleration that has occurred to be sensed. Alternatively, the beam A bends when acceleration occurs in the direction perpendicular to the substrate face of the silicon substrate 302, and the bending of the beam A is sensed by means of sensing a change in piezoresistance (not shown), this allowing the acceleration that has occurred to be sensed. Further, it is also possible to sense acceleration occurring in a direction parallel to the substrate face of the silicon substrate 302.

(SECOND BACKGROUND TO THE INVENTION)

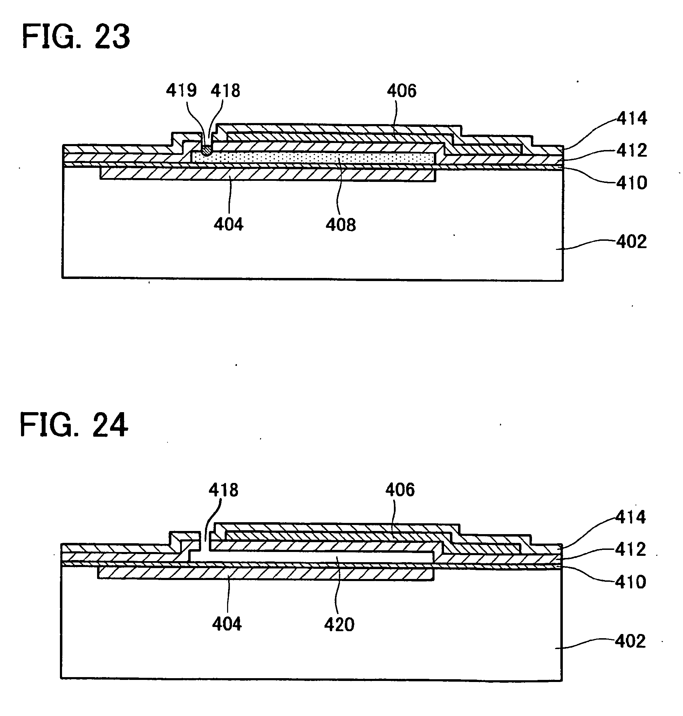

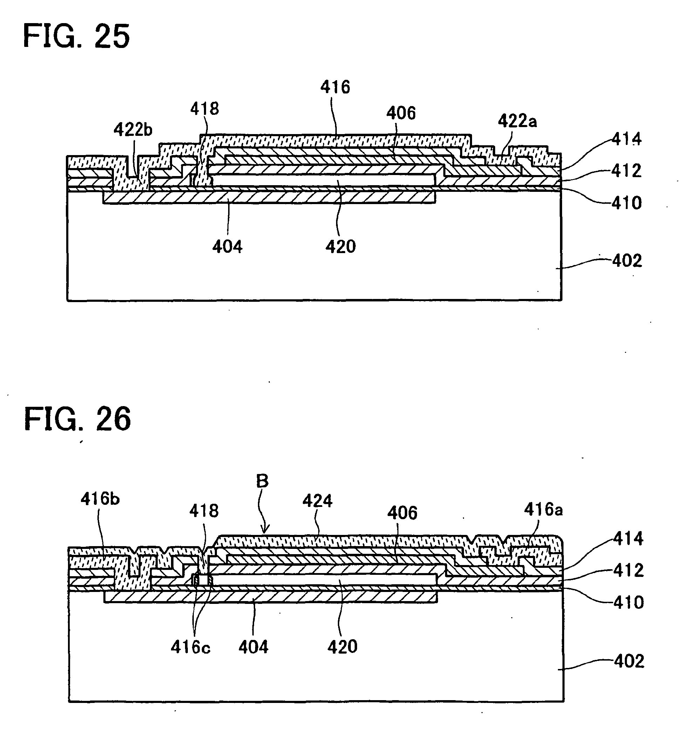

Described next with reference to FIGS. 23 to 26 is another example of manufacturing method utilizing a silicon material processing technique, whereby a silicon structure having a hollow space 420 (shown in FIG. 26) is manufactured. This silicon structure has a diaphragm B located above the hollow space 420.
First, as shown in FIG. 23, impurities are introduced locally into a monocrystal silicon substrate 402, forming a lower electrode 404. Nitriding is performed on a surface face of the silicon substrate 402, forming a lower silicon nitride layer 410. A polycrystal silicon layer 408 is formed along a prescribed area above the lower silicon nitride layer 410. In this example, the polycrystal silicon layer 408 is the sacrificial layer. An upper first silicon nitride layer 412 is formed so as to cover the polycrystal silicon layer 408. An upper electrode 406 is formed above the upper first silicon nitride layer 412 along a prescribed area thereof. The upper electrode 406 is formed from polycrystal silicon, or the like. An upper second silicon nitride layer 414 is formed so as to cover the upper electrode 406. Etching is performed on the upper silicon nitride layers 412 and 414 at a portion thereof not having the upper electrode 406 located thereon, this forming an etching hole 418 that extends to the polycrystal silicon layer 408. By this means, a portion of the polycrystal silicon layer 408 is exposed. As a result, the exposed portion of the polycrystal silicon layer 408 is oxidized, forming a natural oxide film (silicon oxide) 419.

The silicon structure obtained via the process described above is introduced into an etching vessel of a silicon oxide wet etching device, and is immersed in etchant. This etchant is the previously-mentioned diluted solution of hydrofluoric acid (dilute HF), or the like. Hydrogen fluoride solution etches silicon oxide, but barely etches silicon nitride. As a result, as shown in FIG. 24, the natural oxide film 419 is removed by the wet etching. Next, the silicon structure which has had the natural oxide film 419 removed is housed within an etching reaction chamber of a silicon dry etching device. In this device, a gas that etches silicon but barely etches silicon nitride is supplied into the etching reaction chamber, and dry etching is performed on the polycrystal silicon layer 408 that comprises the sacrificial layer. By this means, the hollow space 420 is formed.

Then, as shown in FIG. 25, contact holes 422a and 422b are formed on the upper electrode 406 and the lower electrode 404 respectively. Next, an aluminum layer 416 that will serve as a wiring layer is formed over a surface face of the silicon structure. Then, as shown in FIG. 26, patterning is performed on the aluminum layer 416, forming a wiring layer 416a that makes contact with the upper electrode 406 and a wiring layer 416b that makes contact with the lower electrode 404. Then a sealing layer 424 is formed, sealing the etching hole 418. By this means, a hollow silicon structure having the hollow space 420 is manufactured. This structure functions as a pressure sensor.

With this structure, a prescribed portion B of the upper silicon nitride layers 412 and 414, the upper electrode 406, and the sealing layer 424, functions as a diaphragm. The hollow space 420 is a hermetically sealed space functioning as a pressure reference chamber. With this structure, the diaphragm B bends in response to the difference between the reference pressure and pressure exerted on the diaphragm B. When the diaphragm B bends, the distance between the upper electrode 406 and the lower electrode 404 changes. When the distance between the two electrodes 404 and 406 changes, the electrostatic capacity between these two electrodes 404 and 406 changes. The magnitude of pressure exerted on the diaphragm B can be sensed by sensing the degree of change in the electrostatic capacity:

US 5,013,398 discloses a plasma etch process to anisotropically etch a sandwich structure of silicon dioxide, polycrystalline silicon, and silicon dioxide in situ in a single etch chamber.

US 5,286,344 discloses a process for etching a multilayer structure to form a predetermined etched pattern therein, comprising: providing a multilayer structure, the outer layers of the multilayer structure comprising a silicon dioxide outer layer on an underlying silicon nitride stop layer; forming on the top surface of the multilayer structure a chemical etchant resistant layer having a pattern of openings therein and thereby exposing areas of the silicon dioxide outer layer corresponding to the pattern of openings; and etching the exposed areas of the silicon dioxide outer layer to the silicon nitride stop layer at a high $SiO_2$ etch rate and at a high level of selectivity of said $SiO_2$ etch rate with respect to said $Si_3N_4$ etch rate, with a fluorinated chemical etchant system including an etchant material and an additive material, said additive material comprising a fluorocarbon material in which the number of hydrogen atoms is equal to or greater than the number of fluorine atoms, and said etching step forming an etch pattern in the silicon dioxide outer layer in which the contact side walls of said $SiO_2$ outer layer are perpendicular to the multilayer structure layers.

The Japanese application JP 10-209088 A discloses a surface micromachining process of etching silicon selectively with respect to silicon nitride.

In both of the backgrounds to the invention, wet etching is performed in order to remove silicon oxide. However, when wet etching is performed, two further processes must be performed: the etching fluid applied to the silicon structure must be washed away, and then the silicon structure must be dried. Consequently, the manufacturing process for the structure becomes complicated.

Further, when wet etching is performed, there is a danger of an occurrence of the so-called sticking phenomenon. That is, during the washing and drying processes that follow the wet etching, the surface tension of the liquid causes the layers surrounding the hollow space of the hollow structure to adhere to one another. If the sticking phenomenon occurs, the structure essentially fails to function as a sensor, actuator, etc. That is, the sticking phenomenon creates defective articles, causing a drop in yield.

To use the first background to the invention as an example, if the silicon layer 312 that functions as the mass or beam A adheres to the silicon substrate 302 in the structure shown in FIG. 22, the degree to which the mass A moves or the degree to which the beam A bends in response to acceleration is considerably reduced. As a result, the structure essentially fails to function as an acceleration sensor.

To use the second background to the invention as an example, if the upper first silicon nitride layer 412 that functions as the diaphragm B (shown in FIG. 26) adheres to the lower silicon nitride layer 410, the degree to which the diaphragm B bends in response to pressure is considerably reduced. As a result, the structure essentially fails to function as a pressure sensor.

Sensors, actuators, and the like require a high degree of sensitivity and accuracy. In order to fulfill these requirements, the tendency is to reduce the rigidity of the structure and to miniaturize the size of the structure. However, the likelihood of the sticking phenomenon occurring as a result of wet etching increases when the rigidity of the structure is reduced or the size of the structure is miniaturized. Consequently, the number of defective articles produced as a result of wet etching has increased in recent years.

In other words, if the production of defective articles is to be avoided, the structure must be more rigid and larger in size. As a result, structures that function as highly sensitive or highly accurate sensors, actuators, etc. cannot be realized.

Further, in the manufacturing process of the second background to the invention, the aluminum layer 416 enters the hollow space 420 via the etching hole 418 when the aluminum layer 416 is formed (see FIG. 25). As a result, as shown in FIG. 26, a portion 416c of the aluminum that has entered therein might not be removed after patterning, and may remain within the hollow space 420. Aluminum 416c remaining within the hollow space 420 will interfere with the bending of the diaphragm B when pressure is exerted on this diaphragm B. That is, a structure is manufactured that essentially fails to function as a pressure sensor, and a defective article is produced.

This type of problem does not occur if the aluminum layer 416 can be formed before etching is performed on the natural oxide film 419 and the silicon layer 408 (see FIG. 23). However, the hydrogen fluoride solution used to etch the natural oxide film 419 also etches the aluminum layer 416. As a result, in the second background to the invention, the aluminum layer 416 of FIG. 25 must be formed after the natural oxide film 419 and the silicon layer 408 of FIG. 23 have already been etched. Moreover, the same problem occurs with the silicon structure of the first background to the invention.

Furthermore, it is important to reduce the sticking phenomenon not only-during the manufacture of the silicon structure, but also during use. Reducing the occurrence of the sticking phenomenon during use would mean that the likelihood of the silicon structures being faulty during use would be smaller.

The above has been a description of the problems occurring during wet etching, wherein hydrogen fluoride solution, etc. is used to etch silicon oxide. To counter these problems, a device capable of dry etching silicon oxide using hydrogen fluoride gas has appeared in recent years. The technique related to this has been described in JP laid-open paten publications of TOKKAIHEI 8-116070 and TOKKAIHEI 4-96222. However, complex action is also required when using these devices since the silicon structure must be transferred between an etching reaction chamber of a silicon dry etching device and an etching reaction chamber of a silicon oxide dry etching device. This action renders the manufacturing process more complex. Further, the silicon structure is exposed to the outside air while being transferred. This may cause defective articles to be produced during the manufacture of the silicon structure, or cause faulty articles to become apparent during use. In particular, if dry etching is performed on the natural oxide film formed on the surface face of the silicon and the silicon structure is then transferred for silicon dry etching, the exposure of the silicon structure to the outside air may result in another natural oxide film being formed on the surface face of the silicon.

In this manner, if the silicon and the silicon oxide are etched in separate etching devices, the above problems occur, and costs increase. As a result, the manufacture of silicon structures is usually performed in the manner described in the first and second backgrounds to the invention, the silicon being etched in the silicon dry etching device, and the silicon oxide being etched in the silicon wet etching device that is widely utilized conventionally.

The first purpose of the present invention is to simplify the manufacturing process of the silicon structure.

The second purpose of the present invention is to reduce the number of defective articles produced during the manufacture of the silicon structure, or to reduce the number of faulty articles appearing during use.

The third purpose of the present invention is to realize a silicon structure functioning as a highly sensitive or highly accurate sensor, actuator, etc.

The present invention aims to solve at least one of the above problems.

Moreover, neither the silicon dry etching device nor the silicon oxide dry etching device described above were devised with the intention of processing structures that function as sensors, actuators, etc. Rather, they were devised with the intention of processing semiconductor devices such as MOS, etc. It is frequently the case that, in the processing of semiconductor devices such as MOS, etc., the materials that require etching consist only of silicon or only of silicon oxide. Further, if both silicon and silicon oxide must be etched, one of the materials (either the silicon or the silicon oxide) is etched, then further processing is performed (for example, crystal growth, film formation, etc.). Then the other of the materials (either the silicon oxide or the silicon) is etched. The silicon dry etching device and the silicon oxide dry etching device described above were devised for this type of usage. However, it is rare, when processing semiconductor devices such as MOS etc., that one of the materials (either the silicon or the silicon oxide) must first be etched and then the other of the materials (either the silicon oxide or the silicon) must subsequently be etched.

In view of this situation, the present inventors have considered how a technique suitable for manufacturing silicon structures might be realized. Their solution is the method as claimed in claim 1. Further developments of the present invention are set out in the dependent claims. This method effectively solves the problems, described above, concerning the silicon structures.

The device used in the method is a device developed with the primary consideration of manufacturing silicon structures that function as sensors, actuators, etc.

The method according to the present invention is performed in a device provided with first gas supply members, second gas supply members, an etching reaction chamber, a selective connecting means, and a gas discharging means. The first gas is a gas that etches silicon oxide and barely etches silicon nitride. The second gas is a gas that etches silicon and barely etches silicon nitride. The selective connecting means selectively connects the etching reaction chamber with either the first gas supply members or the second gas supply members. The gas discharging means discharges gas from the etching reaction chamber.

According to the above aspect, connecting the first gas supply members with the etching reaction chamber by means of the selective connecting means allows the first gas to be supplied to the etching reaction chamber. Supplying the first gas to the etching reaction chamber allows at least a portion of the silicon oxide to be dry etched, and thereby removed, while any existing silicon nitride is barely etched. The first gas can be discharged from the etching reaction chamber by means of the gas discharging means. Connecting the second gas supply members with the etching reaction chamber by means of the selective connecting means allows the second gas to be supplied to the etching reaction chamber. Supplying the second gas to the etching reaction chamber allows at least a portion of the silicon to be dry etched, and thereby removed, while any existing silicon nitride is barely etched. The first gas may of course be supplied after the second gas has been supplied.

According to the above aspect, wet etching so as to remove silicon oxide does not need to be performed. Consequently, there is no need to perform the processes of washing away the etching fluid applied to the silicon structure, and drying the silicon structure subsequent to this washing. As a result, the manufacturing process for the silicon structure is simpler.

Furthermore, since wet etching so as to remove silicon oxide does not need to be performed, there is a greatly decreased likelihood of the sticking phenomenon occurring during manufacturing. As a result, the number of defective articles created during manufacturing can be reduced. Put differently, the rigidity and the size of the structure can be reduced compared to the case where wet etching is performed. As a result, structures can be produced that function as highly sensitive or highly accurate sensors, actuators, etc.

Moreover, the silicon and the silicon oxide can be dry etched in the same etching reaction chamber. As a result, there is no need for the troublesome action of transferring the silicon structure between the etching reaction chamber of the silicon dry etching device and the etching reaction chamber of the silicon oxide dry etching device. Consequently, the manufacturing process is simpler. Since there is no need to transfer the silicon structure between the etching reaction chambers, the silicon structure need not be exposed to the outside air while being transferred. In particular, the problem is prevented in which a second natural oxide film forms on the surface face of the silicon after dry etching has been performed on the natural oxide film. As a result, a reduction is possible in the number of defective articles produced during manufacture of the silicon structure, or in the number of faulty articles becoming apparent during use.

The above effects are also obtained in other aspects described below.

According to the present invention it is preferred that the gas supply members have a housing member for gas producing material, the gas producing material being either solid or liquid. Further, it is preferred that a gas transforming means is provided, this transforming the solid or liquid material into gas.

According to the above aspect, the gas producing material can be stored in a solid or liquid state within the housing member, these being easier to handle than gas. When gas needs to be supplied into the etching reaction chamber, the solid or liquid material can be transformed into gas and supplied therein. As a result, the device is rendered more convenient.

It is preferred that the gas supply members further have a storage member for the gas that has been transformed from the solid or the liquid material.

According to the above aspect, the gas that has been transformed from the solid or the liquid can be stored. If a large quantity of gas is needed for dry etching, this storage of gas allows the situation to be dealt with adequately.

More specifically, the gas supply members may have a vessel for housing solid xenon difluoride ($XeF_2$) or a vessel for housing solid brominetrifluoride ($BrF_3$).

The gas transformed from the solid material stored in these vessels, namely the gasified xenon difluoride gas or the brominetrifluoride gas, has the property of etching silicon and barely etching silicon oxide, silicon nitride, or aluminum materials. As a result, the gas producing raw materials stored in these vessels produce gases suitable as the second gas.

Alternatively, the gas supply members may have a vessel for housing hydrogen fluoride (HF) solution, and a vessel for housing methyl alcohol ($CH_3OH$) solution or water ($H_2O$).

The gas produced from materials stored in these vessels, namely the mixed gas of hydrogen fluoride and methyl alcohol or hydrogen fluoride and water, has the property of etching silicon oxide and barely etching silicon, silicon nitride, or aluminum materials. As a result, the gas producing raw materials stored in these vessels produce gases suitable as the first gas.

It is preferred that a means is provided for preventing liquid from blocking a space between a liquid housing member and the etching reaction chamber in the case where the liquid stored within the liquid housing member is transformed into gas and supplied to the etching reaction chamber.

According to this aspect, the liquid is prevented from blocking the space between the liquid housing member and the etching reaction chamber even in the case where the liquid of the liquid housing member boils up while being transformed into gas and enters piping etc. between the liquid housing member and the etching reaction chamber.

It is preferred that the gas transforming means is a pressure reducing means for reducing pressure within a solid housing member or the liquid housing member. Further, it is preferred that the pressure reducing means is connected with the solid or the liquid housing member via the etching reaction chamber.

According to this aspect, the solid or the liquid within the housing member can be transformed into a gas and the transformed gas can be guided rapidly into the etching reaction chamber.

According to the present invention it is preferred that the interior of the etching reaction chamber is provided with a means for preventing gas from flowing directly from gas supply holes to gas discharge holes.

Providing the preventing means allows the gas to flow more uniformly within the etching reaction chamber.

According to the present invention the gas discharging means has a rapid discharging means and a slow discharging means. Providing these discharging means allows an efficient discharge of the gas, the gas usually being discharged slowly, for example, and being discharged rapidly only when necessary.

According to the present invention it is preferred that an etching completion sensing means is further provided, this sensing the completion of etching of the silicon structure.

Providing the etching completion sensing means has the result that, even if, for example, the size of silicon structures varies widely, more etching than necessary will not be performed, nor will insufficient etching be performed.

According to the present invention it is preferred that a vessel for housing organosilicic compound, a vessel for housing water, a gas producing means for producing gas from the organosilicic compound and water housed within these vessels, and a coating chamber connecting with these vessels are further provided.

This aspect is a further useful technique for preventing the occurrence of the sticking phenomenon during use of the silicon structure. According to the above aspect, a water-repellent film can be coated onto a surface face of the silicon structure formed as described above. By this means, the silicon structure becomes more water repellent. This prevents the problem of liquid adhering to the structure and the surface tension thereof causing the sticking phenomenon to occur even if the structure is being utilized in, for example, surroundings in which dew condensation readily occurs. As a result, a reduced number of defective articles become apparent during use.

Further, a connecting member, an opening and closing means, and a silicon structure conveying means of the following types may be provided. The connecting member connects the etching reaction chamber with the coating chamber in a manner whereby space between the two chambers is isolated from the outside. The opening and closing means is capable of switching a connection between the etching reaction chamber and the coating chamber between an open state and a closed state. The silicon structure conveying means is capable of conveying the silicon structure between the etching reaction chamber and the coating chamber. Alternatively, a preparatory chamber, a connecting member, an opening and closing means, and a silicon structure conveying means of the following types may be provided. The connecting member connects the etching reaction chamber with the preparatory chamber and connects the preparatory chamber with the coating chamber in a manner whereby space between the chambers is isolated from the outside. The opening and closing means is capable of switching a connection between the etching reaction chamber and the preparatory chamber, and a connection between the preparatory chamber and the coating chamber, between an open state and a closed state. The silicon structure conveying means is capable of conveying the silicon structure between the etching reaction chamber and the preparatory chamber, and between the preparatory chamber and the coating chamber.

According to the above aspect, after dry etching of the silicon structure has been completed in the etching reaction chamber, the silicon structure can be conveyed to the coating chamber without its coming into contact with the outside air. As a result, oxidization etc. of the silicon structure can be prevented. Further, the provision of the preparatory chamber allows the silicon structure to be transferred easily between the etching reaction chamber and the coating chamber.

In the present specification, included among the gases that etch a first material (for example, silicon) and barely etch a second material (for example, silicon oxide), are gases for which the speed of etching of the first material with respect to the speed of etching the second material (i.e. an etching selection ratio) is 15. An etching selectivity ratio of 20 or greater is preferred, and an etching selectivity ratio of 30 or greater is more preferred. Moreover, gases that do not etch the second material at all are of course included among the gases that barely etch the second material.

BRIEF DESCRIPTION OF THE DRAWINGS

Figure 1 shows the configuration of a first device for manufacturing a silicon structure according to the claimed method.

Figure 2 shows the configuration of an etching reaction chamber of the first device for manufacturing a silicon structure according to the claimed method.

Figure 3 shows the configuration between a methyl alcohol vessel and a dry pump of the first device for manufacturing a silicon structure according to the claimed method.

Figure 4 shows a portion of a first process for manufacturing a silicon structure as a comparative example, this utilizing the first device for manufacturing a silicon structure as shown in Figures 1 to 3 and a different silicon material processing technique, sequence (1).

Figure 5 shows a portion of the above manufacturing process, sequence (2).

Figure 6 shows a portion of the above manufacturing process, sequence (3).

Figure 7 shows a portion of process according to the present invention for manufacturing a silicon structure, this utilizing the first device for manufacturing a silicon structure as shown in Figures 1 to 3 and a different silicon material processing technique, sequence (1).

Figure 8 shows a portion of the above manufacturing process, sequence (2).

Figure 9 shows a portion of the above manufacturing process, sequence (3).

Figure 10 shows portion of the above manufacturing process, sequence (4).

Figure 11 shows a portion of the above manufacturing process, sequence (5).

Figure 12 shows a portion of the above manufacturing process, sequence (6).

Figure 13 shows a portion of the above manufacturing process, sequence (7).

Figure 14 shows the configuration of a second device for manufacturing a silicon structure according to the claimed method.

Figure 15 shows the configuration of a third device for manufacturing a silicon structure according to the claimed method.

Figure 16 shows a first variation of the configuration between the methyl alcohol vessel and the dry pump.

Figure 17 shows a second variation of the configuration between the methyl alcohol vessel and the dry pump.

Figure 18 shows a third variation of the configuration between the methyl alcohol vessel and the dry pump.

Figure 19 shows a fourth variation of the configuration between the methyl alcohol vessel and the dry pump.

Figure 20 shows a portion of a conventional manufacturing process of a first silicon structure, sequence (1).

Figure 21 shows a portion of the above manufacturing process, sequence (2).

Figure 22 shows a portion of the above manufacturing process, sequence (3).

Figure 23 shows a portion of a conventional manufacturing process of a second silicon structure, sequence (1).

Figure 24 shows a portion of the above manufacturing process, sequence (2).

Figure 25 shows a portion of the above manufacturing process, sequence (3).

Figure 26 shows a portion of the above manufacturing process, sequence (4).

PREFERRED EMBODIMENTS FOR PRACTICING THE INVENTION

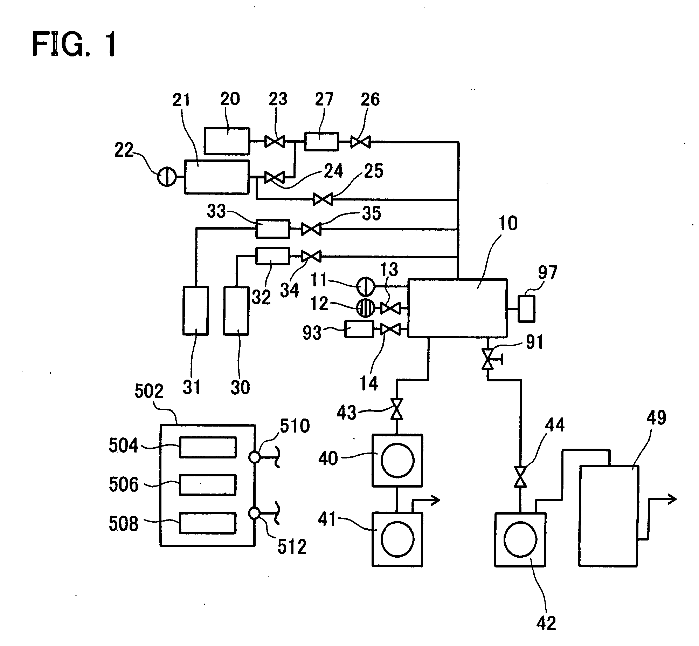

FIG. 1 shows the configuration of a first device for manufacturing a silicon structure (hereafter referred to as first structure manufacturing device') according to the claimed method. Since this first device can be used for the entire processing of silicon material, it may equally well be referred to as a first silicon material processing device. That is, the term first structure manufacturing device' used below may equally well be replaced with first silicon material processing device.

The first structure manufacturing device is provided with a xenon difluoride vessel 20, a sublimated gas storage vessel 21, a hydrogen fluoride vessel 30, a methyl alcohol vessel 31, an etching reaction chamber 10, a dry pump 42, a toxic substance removal device 49, a turbo-molecular pump 40, a rotary pump 41, and a control member 502, etc.

Solid xenon difluoride $XeF_2$ is housed within the xenon difluoride vessel 20. The xenon difluoride is solid at regular temperature and at atmospheric pressure. Xenon difluoride gas that has been sublimated from the solid state $XeF_2$ is temporarily stored in the sublimated gas storage vessel 21. Pressure within the xenon difluoride vessel 20 is reduced by the dry pump 42, or the like, this sublimating the solid xenon difluoride within the vessel 20, and thereby gasifying the xenon difluoride gas. Hydrogen fluoride (HF) solution is housed within the hydrogen fluoride vessel 30. Methyl alcohol ($CH_3OH$) solution is housed within the methyl alcohol vessel 31. The dry pump 42 reduces the pressure within the etching reaction chamber 10 and the vessels 20, 30, and 31. The toxic substance removal device 49 detoxifies the exhaust gas discharged from the dry pump 42. The turbo-molecular pump 40 and the rotary pump 41 reduce the pressure within the etching reaction chamber 10 and the vessels 20, 30, and 31 more rapidly than the dry pump 42.

The control member 502 has a CPU 504, a ROM 506 that stores a control program or the like, a RAM 508 that temporarily stores data etc., an input port 510, an output port 512, and so on.

Piping between the etching reaction chamber 10 and the xenon difluoride vessel 20 is provided with a third valve 23, a first flow meter 27, and a sixth valve 26. Between the etching reaction chamber 10 and the sublimated gas storage vessel 21 there is piping provided with a fourth valve 24, the first flow meter 27, and the sixth valve 26, as well as piping provided with a fifth valve 25.

Piping between the etching reaction chamber 10 and the hydrogen fluoride vessel 30 is provided with a second flow meter 32 and a seventh valve 34. Piping between the etching reaction chamber 10 and the methyl alcohol vessel 31 is provided with a third flow meter 33 and an eighth valve 35.

Piping between the etching reaction chamber 10 and the turbo-molecular pump 40 is provided with a ninth valve 43. Piping between the etching reaction chamber 10 and the dry pump 42 is provided with a first throttle valve 91 and a tenth valve 44.

A first pressure meter 11 is connected with the etching reaction chamber 10. A first vacuum meter 12 is connected with the etching reaction chamber 10 via a twelfth valve 13. A nitrogen gas supply member 93 is connected with the etching reaction chamber 10 via a second valve 14.

An etching completion sensor 97, for sensing when etching of a silicon structure is complete, is provided on the etching reaction chamber 10. The etching completion sensor 97 may either use some means to sense that etching is complete on the portion of the silicon structure requiring etching, or may identify the completion of etching on the basis of some provided condition. However, the preferred technique is that developed by the present inventors and set forth in Japanese Laid Open Patent Publication TOKKAI 2001-185530.

The control member 502 is electrically connected with the valves 13, 14, 23 to 26, 34, 35, 43, and 44, pressure meters 11 and 22, the flow meters 27, 32, and 33, the pumps 40 to 42, the first vacuum meter 12, the toxic substance removal device 49, and the etching completion sensor 97, etc. The function of the control member 502 is to monitor and control the actions of these members.

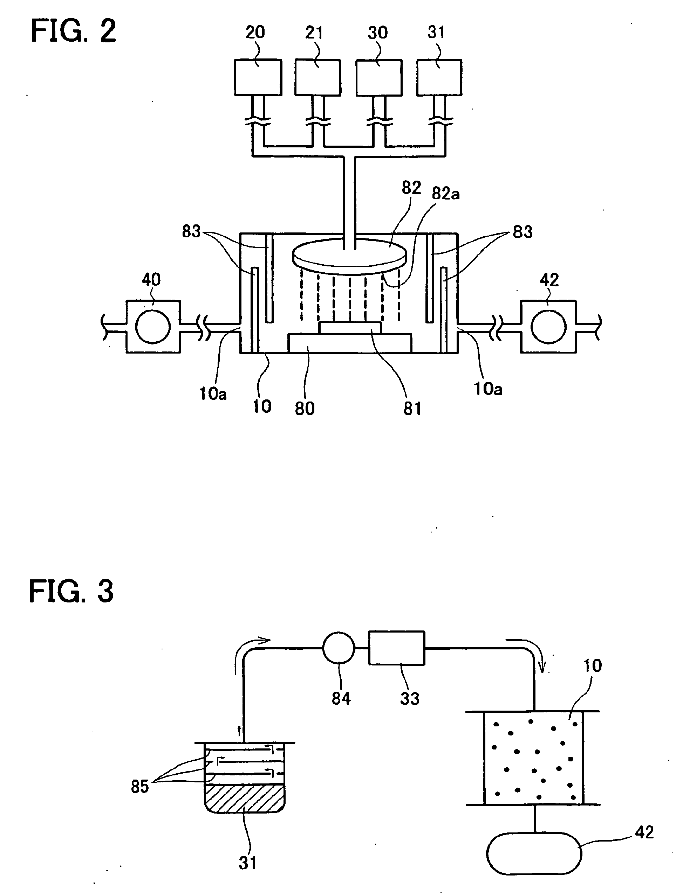

As shown in FIG. 2, the etching reaction chamber 10 has provided therein: a silicon structure table 80, a shower plate 82, and double blocking sheets 83.

The silicon structure table 80 is capable of having placed thereon a silicon structure 81 that is to be manufactured into a structure by means of dry etching. It is preferred that a surface face of the silicon structure table 80 is provided with grooves or a small number of minute protrusions formed in a radiating shape. The provision of these grooves or protrusions prevents a pressure difference from appearing between the two sides of the silicon structure 81. By this means, damage is prevented even if the silicon structure 81 is formed from fragile material. Further, the silicon structure 81 is thereby prevented from making close contact with the surface face of the silicon structure table 80.

The shower plate 82 is formed in a disc shape, a lower face thereof having a plurality of gas supply holes 82a. It is preferred that the shower plate 82 is attached to a rotating axis such that the shower plate 82 is capable of rotating. Furthermore, a connecting portion that connects the rotating axis and the disc is preferably a dynamic seal that allows the disc to oscillate. Allowing the disc to rotate or oscillate permits gas to be showered almost uniformly across the entirety of the etching reaction chamber 10. Moreover, it is preferred that gas supply piping and the rotating axis are formed separately. If the gas supply piping is formed from soft piping, and the connecting portion that connects the soft piping and the disc is a fixed seal, gas can reliably be prevented from leaking. Further, since there is no need to be concerned that gas may leak from the connecting portion of the rotating axis, the structure of the dynamic seal can be simplified. Moreover, it is preferred that the soft piping is wound around the central axis of oscillation.

The two double blocking sheets 83 prevent gas from flowing directly from the gas supply holes 82a of the shower plate 82 to gas discharge holes 10a. Providing the blocking sheets 83 allows the gas to be dispersed in a variety of directions within the etching reaction chamber 10. As a result, the gas can be supplied almost uniformly to the entirety of the silicon structure 81 within the etching reaction chamber 10. Providing the blocking sheets 83 allows the silicon structure 81 to be etched almost uniformly even in the case where gas is continuously supplied so that etching is continuously performed.

As shown in FIG. 3, three blocking sheets 85 are installed in a maze structure within the methyl alcohol vessel 31. The provision of the blocking sheets 85 prevents the methyl alcohol solution from directly entering the piping in the case where the methyl alcohol solution suddenly boils up when the dry pump 42 or the like has reduced the pressure within the methyl alcohol vessel 31. Consequently, the methyl alcohol solution is prevented from blocking a filter 84 within the piping.

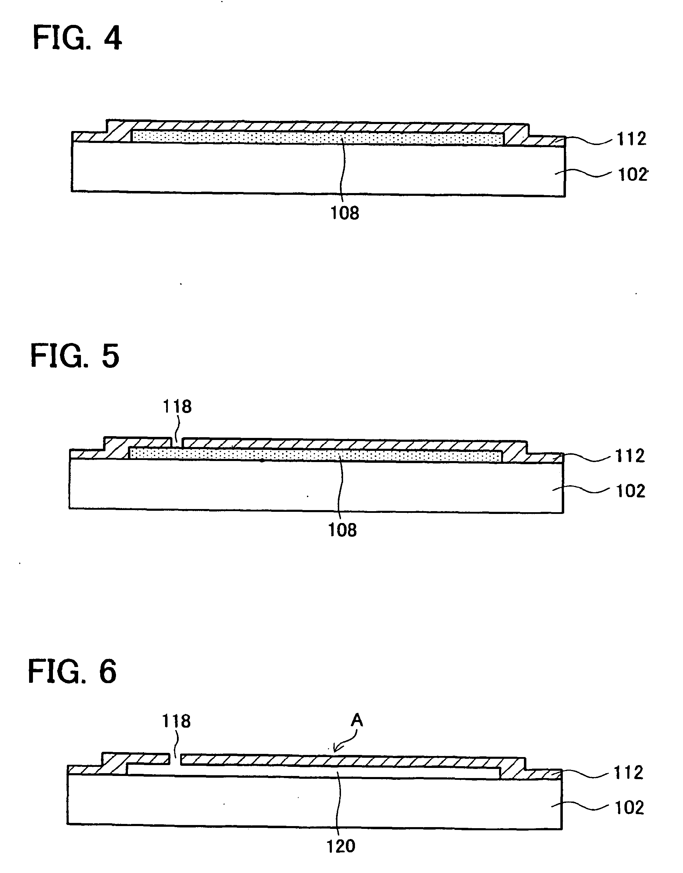

Next, a comparative method for manufacturing a silicon structure having a hollow space 120, such as for example that shown in FIG. 6, is described with reference to FIGS. 4 to 6. This utilizes the first structure manufacturing device, configured as described above, and a comparative silicon material processing technique. The silicon structure has a beam or mass A extending above the hollow space 120. The manufacturing method therefor is in contrast to that for the first background to the invention, shown in FIGS. 20 to 22.

First, a device different from the first structure manufacturing device described above performs the following processes. First, a silicon oxide layer 108 is formed by means of CVD (Chemical Vapor Deposition), or the like, along a prescribed area above a silicon substrate 102 (see FIG. 4). Next, a silicon layer 112 is formed by, for example, CVD, or the like so as to cover the silicon oxide layer 108.

The silicon structure shown in FIG. 4, obtained via the process described above, is housed within the etching reaction chamber 10 of the first structure manufacturing device shown in FIG. 1.

The following processes are performed within the first structure manufacturing device. First, the xenon difluoride gas, which etches silicon, is supplied into the etching reaction chamber 10, and the silicon layer 112 is locally dry etched. The xenon difluoride gas is capable of etching silicon (Si: this encompasses both polycrystal silicon and monocrystal silicon), but barely etches silicon oxide ($SiO_2$), silicon nitride (SiN: typically $Si_2N_4$), or aluminum (Al). Specifically, silicon is etched by the xenon difluoride gas at a speed of approximately 4600 Å/min (1 Å = 0.1 nm) silicon oxide is etched at a speed of approximately 0 Å/min, silicon nitride is etched at a speed of approximately 120 Å/min, and aluminum is etched at a speed of approximately 0 Å/min. However, these values can vary according to differing conditions.

Methods of performing local dry etching may be, but are not restricted to, supplying gas while all but the portion on which etching is desired is masked with a resist, or supplying gas locally to the portion on which etching is desired. Any method of performing local dry etching is acceptable. If masking with a resist is employed, the resist must be a material that is barely etched by gas (in this example, xenon difluoride gas). By this means, an etching hole 118 is formed that extends to the silicon oxide layer 108 (see FIG. 5). As a result, a portion of the silicon oxide layer 108 is exposed. Then, the xenon difluoride gas is discharged from the etching reaction chamber 10. Next, a mixed gas, consisting of methyl alcohol and hydrogen fluoride, is supplied into the etching reaction chamber 10, and the entirety of the silicon oxide layer 108 is dry etched. The mixed methyl alcohol and hydrogen fluoride gas is capable of etching silicon oxide ($SiO_2$), but barely etches silicon (Si: this encompasses both polycrystal silicon and monocrystal silicon), silicon nitride (SiN: typically $Si_3N_4$), or aluminum (Al). Specifically, the silicon oxide is etched by the mixed methyl alcohol and hydrogen fluoride gas at a speed of approximately 1000 Å/min, silicon is etched at a speed of approximately 0 Å/min, silicon nitride is etched at a speed of approximately 10 Å/min, and aluminum is etched at a minute value, at a speed below approximately 1 Å/min. However, these values can vary according to differing conditions.

The silicon oxide layer 108 is a layer whose purpose is to finally be removed so as to produce the hollow space 120, as shown in FIG. 6. This layer is usually termed the 'sacrificial layer.' By this means, a silicon structure having the hollow space 120 is manufactured (see FIG. 6).

This structure may, for example, be utilized as an acceleration sensor. When it is utilized as an acceleration sensor, a portion A of the silicon layer 112 is utilized as a beam or mass that moves when acceleration occurs. For example, when acceleration occurs in a direction perpendicular to a substrate face of the silicon substrate 102, the mass A moves in a direction perpendicular to the substrate face. The movement of the mass A is sensed by means of sensing a change in the electrostatic capacity between electrodes (not shown), this allowing the acceleration that has occurred to be sensed. Alternatively, the beam A bends when acceleration occurs in the direction perpendicular to the substrate face of the silicon substrate 102, and the bending of the beam A is sensed by means of sensing a change in piezoresistance (not shown), this allowing the acceleration that has occurred to be sensed. Further, it is also possible to sense acceleration occurring in a direction parallel to the substrate face of the silicon substrate 102.

Next, the above processes performed by the first structure manufacturing device described above are described in more detail with reference to FIG. 1. First, every valve is closed. In the processes described below, all control may be performed by the control programs, etc. of the control member 502, or an operator may perform a portion thereof by hand.

First, the first throttle valve 91, the tenth valve 44, the sixth valve 26, and the third valve 23 are opened, the dry pump 42 is started, and pressure is reduced in the etching reaction chamber 10 and in the xenon difluoride vessel 20. The xenon difluoride is sublimated at a pressure at or below 3.8 Torr (1 Torr = 133 Pa). The solid xenon difluoride housed within the xenon difluoride vessel 20 is sublimated by this pressure reduction process, becoming a gas. The xenon difluoride gas is introduced into the etching reaction chamber 10 by the suction pressure of the dry pump 42, and is also discharged via the dry pump 42. By this means, gas etc. that has remained within the etching reaction chamber 10 is expelled. After discharge, the tenth valve 44, the sixth valve 26, and the third valve 23 are closed.

Next, the second valve 14 is opened, nitrogen gas is supplied into the etching reaction chamber 10 from the nitrogen gas supply member 93, and atmospheric pressure is established within the etching reaction chamber 10. In this state of atmospheric pressure, a door of the etching reaction chamber 10 is opened and the silicon structure 81 (as shown in FIG. 2) is placed on the silicon structure table 80. After the silicon structure 81 has been placed thereon, the door is closed and the second valve 14 is closed.

Next, the first throttle valve 91, the tenth valve 44, the third valve 23, and the sixth valve 26 are opened, the dry pump 42 is started, and pressure is reduced in the etching reaction chamber 10 and in the xenon difluoride vessel 20. As a result, the solid xenon difluoride housed within the xenon difluoride vessel 20 is sublimated and becomes a gas, and is introduced into the etching reaction chamber 10. The pressure within the etching reaction chamber 10 is monitored by the first pressure meter 11, and when a prescribed pressure is attained the third valve 23 and the sixth valve are closed and the xenon difluoride gas is enclosed within the etching reaction chamber 10. The xenon difluoride gas locally etches the silicon layer 112 (see FIG. 5) of the silicon structure 81 within the etching reaction chamber 10, forming the etching hole 118. The formula (1) showing the reaction for the etching is as follows:

$$2XeF_2 + Si \longrightarrow 2Xe + SiF_4 \tag{1}$$

When the etching completion sensor 97 senses that the xenon difluoride gas has completed etching the portion of the silicon layer 112 that requires this process, the tenth valve 44 is opened, and the xenon difluoride gas is discharged from the etching reaction chamber 10 via the dry pump 42 and the toxic substance removal device 49. However, it is equally possible that an etching completion sensor 97 is not provided. For example, the control member 502 may equally well utilize computed or stored data concerning etching periods, an etching period being the period between initiation of etching and the estimated (taking prescribed conditions into account) completion time thereof. This data may either be computed while the device is being operated, or may be computed in advance and stored. 'Prescribed conditions' refers, for example, to the size of the silicon structure, the quantity of gas supplied to the etching reaction chamber, the type of gas, etc.

Next, the first throttle valve 91, the tenth valve 44, the eighth valve 35, and the seventh valve 34 are opened, and the dry pump 42 performs evacuation. Thereupon, the methyl alcohol solution within the methyl alcohol vessel 31 is volatilized and the hydrogen fluoride solution within the hydrogen fluoride vessel 30 is volatilized. The third flow meter 33 monitors the flow of the volatilized methyl alcohol gas, adjusting this flow as required. Further, the second flow meter 32 monitors the flow of the volatilized hydrogen fluoride gas, adjusting this flow as required. The mixed methyl alcohol and hydrogen fluoride gas, the flows thereof having been adjusted, is supplied into the etching reaction chamber 10. Then, the eighth valve 35 and the seventh valve 34 are closed, and the mixed methyl alcohol and hydrogen fluoride gas is discharged from the etching reaction chamber 10. By this means, gas etc. that has remained within the etching reaction chamber 10 is expelled.

Next, the ninth valve 43 is opened, and the turbo-molecular pump 40 and the rotary pump 41 create a high vacuum within the etching reaction chamber 10. Then, the ninth valve 43 is closed, the tenth valve 44, the eighth valve 35, and the seventh valve 34 are opened, and the dry pump 42 performs evacuation, this volatilizing the methyl alcohol solution within the methyl alcohol vessel 31 and the hydrogen fluoride solution within the hydrogen fluoride vessel 30. The third flow meter 33 monitors the flow of the volatilized methyl alcohol gas, adjusting this flow as required. Further, the second flow meter 32 monitors the flow of the volatilized hydrogen fluoride gas, adjusting this flow as required. The mixed methyl alcohol and hydrogen fluoride gas, the flows thereof having been adjusted, is supplied into the etching reaction chamber 10.

The pressure within the etching reaction chamber 10 is monitored by the first pressure meter 11, and the first throttle valve 91 is adjusted, this maintaining a prescribed pressure. By this means, the silicon oxide layer 108 (see FIG. 5) of the silicon structure is etched by the mixed gas. In this case, reactions shown by the following formulae (2) and (3) occur, wherein 'M' represents methyl alcohol.

$$M + 2HF \longrightarrow HF_2^- + MH^+ \qquad (2)$$

$$SiO_2 + 2HF_2^- + 2MH^+ \longrightarrow SiF_4 + 2H_2O + 2M \qquad (3)$$

When the etching completion sensor 97 senses that the mixed gas has completed etching the silicon oxide layer 108, the eighth valve 35 and the seventh valve 34 are closed, and the mixed methyl alcohol and hydrogen fluoride gas is discharged from the etching reaction chamber 10 via the dry pump 42 and the toxic substance removal device 49.

It is possible in this case also that the data concerning etching periods computed or stored by the control member 502 is utilized, and the etching completion sensor 97 is not utilized.

In the above process, the turbo-molecular pump 40 and the rotary pump 41 may be used continuously, instead of the dry pump 42, as a high speed pressure-reducing means to reduce the pressure in the etching reaction chamber 10, the methyl alcohol vessel 31, the hydrogen fluoride vessel 30, the xenon difluoride vessel 20, etc. In that case, the ninth valve 43 is opened, instead of the tenth valve 44, when pressure is to be reduced.

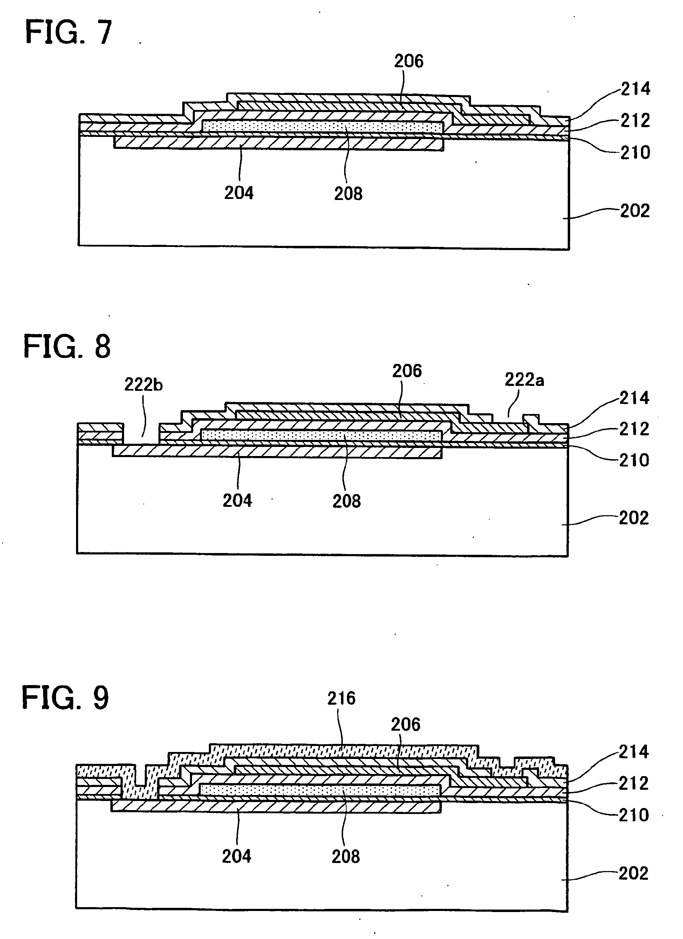

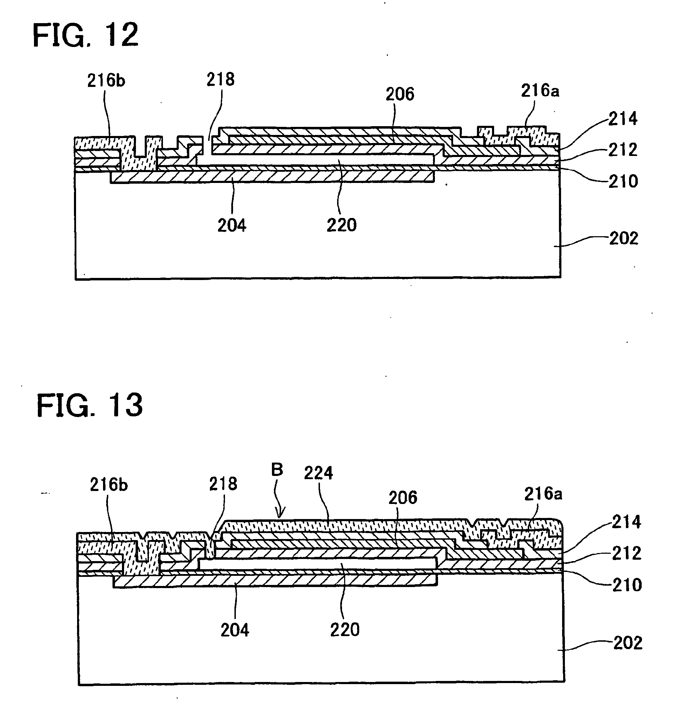

Next, a method according to the present invention for manufacturing a silicon structure having a hollow space 220, as shown in FIG. 13, is described with reference to FIGS. 7 to 13. This utilizes the first structure manufacturing device as described above, and a different silicon material processing technique. The silicon structure has a diaphragm B located above the hollow space 220. The manufacturing method therefor is in contrast to that of the second background to the invention, shown in FIGS. 23 to 26.

First, a device different from the first structure manufacturing device described above performs the following processes.

First, impurities are introduced locally into a monocrystal silicon substrate 202, shown in FIG. 7, to form a lower electrode 204. Nitriding is performed on a surface face of the silicon substrate 202 to form a lower silicon nitride layer 210. A polycrystal silicon layer 208 is formed, by means for example of CVD or the like, along a prescribed area above the lower silicon nitride layer 210. In this example, the polycrystal silicon layer 208 is the sacrificial layer. An upper first silicon nitride layer 212 is formed so as to cover the polycrystal silicon layer 208. An upper electrode 206 is formed above the upper first silicon nitride layer 212 along a prescribed area thereof. The upper electrode 206 is formed from polycrystal silicon, or the like. An upper second silicon nitride layer 214 is formed so as to cover the upper electrode 206.

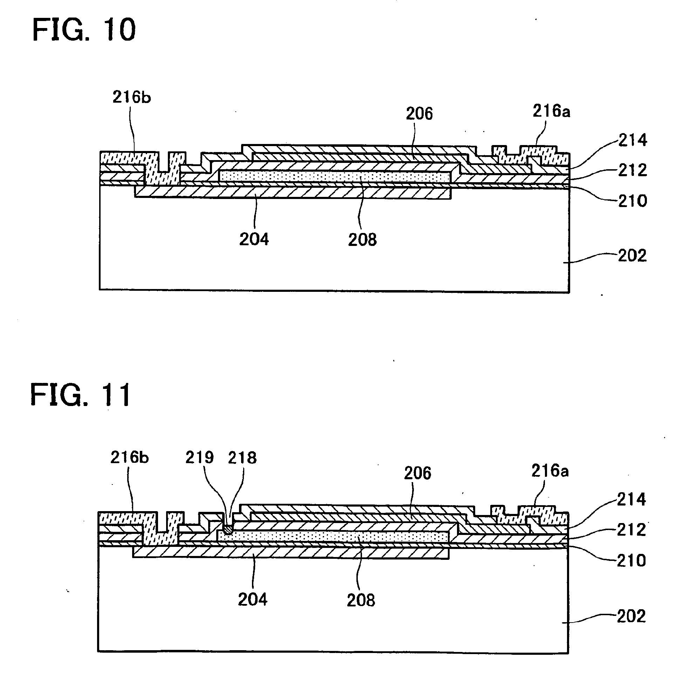

Then, as shown in FIG. 8, contact holes 222a and 222b are formed on prescribed areas of the upper electrode 206 and the lower electrode 204 respectively. Next, as shown in FIG. 9, an aluminum layer 216 that will form a wiring layer is formed over a surface face of the silicon structure. Next, as shown in FIG. 10, patterning is performed on the aluminum layer 216, forming a wiring layer 216a that makes contact with the upper electrode 206, and a wiring layer 216b that makes contact with the lower electrode 204. Then, as shown in FIG. 11, etching is performed on the upper silicon nitride layers 212 and 214 at a portion thereof not having the upper electrode 206 located thereon, this forming an etching hole 218 that extends to the polycrystal silicon layer 208. By this means, a portion of the polycrystal silicon layer 208 is exposed. As a result, the exposed portion of the polycrystal silicon layer 208 oxidizes, forming a natural oxide film (silicon oxide) 219.

The silicon structure shown in FIG. 11, obtained via the process described above, is housed within the etching reaction chamber 10 of the first structure manufacturing device shown in FIG. 1.

The following processes are performed within the first structure manufacturing device. First, the mixed gas, consisting of methyl alcohol and hydrogen fluoride, is supplied into the etching reaction chamber 10 of the structure manufacturing device, and the natural oxide film (silicon oxide) 219 (shown in FIG. 11) is dry etched. As described above, the mixed methyl alcohol and hydrogen fluoride gas is capable of etching silicon oxide, but barely etches silicon (polycrystal silicon and monocrystal silicon), silicon nitride, or aluminum. As a result, a portion of the silicon layer 208, this constituting the sacrificial layer, is exposed. Then, the mixed methyl alcohol and hydrogen fluoride gas is discharged from the etching reaction chamber 10. Next, xenon difluoride gas is supplied into the etching reaction chamber 10, and the silicon layer 208 (shown in FIG. 11) is dry etched. By this means, the state shown in FIG. 12 is attained. As described above, the xenon difluoride gas is capable of etching silicon (polycrystal silicon and monocrystal silicon), but barely etches silicon oxide, silicon nitride, or aluminum.

Then, a sealing layer 224 (as shown in FIG. 13) is formed by a device different from the first structure manufacturing device shown in Fig. 1, sealing the etching hole 218. By this means, a silicon structure having the hollow space 220 is manufactured. This structure functions as a pressure sensor.

With this structure, a prescribed portion B of the upper silicon nitride layers 212 and 214, the upper electrode 206, and the sealing layer 224 functions as a diaphragm. The hollow space 220, this having been formed by the removal of the silicon layer 208 that comprised the sacrificial layer, is a hermetically sealed space that functions as a pressure reference chamber. With this structure, the diaphragm B bends in response to the difference between the reference pressure and pressure exerted on the diaphragm B. When the diaphragm B bends, the distance between the upper electrode 206 and the lower electrode 204 changes. When the distance between the two electrodes 206 and 204 changes, the electrostatic capacity between these two electrodes 206 and 204 changes. The magnitude of pressure exerted on the diaphragm B can be sensed by sensing the degree of change in the electrostatic capacity.

Next, the above processes performed by the first structure manufacturing device described above are described in more detail with reference to FIG. 1. First, every valve is closed. In the processes described below, all control may be performed by the control programs, etc. of the control member 502, or an operator may perform a portion thereof by hand.

First, the first throttle valve 91, the tenth valve 44, the eighth valve 35, and the seventh valve 34 are opened, the dry pump 42 performs evacuation, this volatilizing the methyl alcohol solution within the methyl alcohol vessel 31 and the hydrogen fluoride solution within the hydrogen fluoride vessel 30. The third flow meter 33 monitors the flow of the volatilized methyl alcohol gas, adjusting this flow as required. Further, the second flow meter 32 monitors the flow of the volatilized hydrogen fluoride gas, adjusting this flow as required. The mixed methyl alcohol and hydrogen fluoride gas, the flows thereof having been adjusted, is supplied into the etching reaction chamber 10. Then, the eighth valve 35 and the seventh valve 34 are closed, and the mixed methyl alcohol and hydrogen fluoride gas is discharged from the etching reaction chamber 10. By this means, gas etc. that has remained within the etching reaction chamber 10 is expelled.

Moreover, if a vacuum below $1 \times 10^{-2}$ Pa is required within the etching reaction chamber 10, the tenth valve 44 is closed, the ninth valve 43 is opened, and the turbo-molecular pump 40 and the rotary pump 41 create a vacuum.

Next, the ninth valve 43 and the tenth valve 44 are closed, the second valve 14 is opened, nitrogen gas is supplied into the etching reaction chamber 10 from the N gas supply member 93, atmospheric pressure thereby being established within the etching reaction chamber 10. In this state of atmospheric pressure, the door of the etching reaction chamber 10 is opened and the silicon structure 81 (as shown in FIG. 2) is placed on the silicon structure table 80. After the silicon structure 81 has been placed thereon, the door is closed and the second valve 14 is closed.

Next, the ninth valve 43 is opened, and the turbo-molecular pump 40 and the rotary pump 41 create a high vacuum within the etching reaction chamber 10. Then, the ninth valve 43 is closed, the tenth valve 44, the eighth valve 35, and the seventh valve 34 are opened, the dry pump 42 performs evacuation, this volatilizing the methyl alcohol solution within the methyl alcohol vessel 31 and the hydrogen fluoride solution within the hydrogen fluoride vessel 30. The third flow meter 33 monitors the flow of the volatilized methyl alcohol gas, adjusting this flow as required. Further, the second flow meter 32 monitors the flow of the volatilized hydrogen fluoride gas, adjusting this flow as required. The mixed methyl alcohol and hydrogen fluoride gas, the flows thereof having been adjusted, is supplied into the etching reaction chamber 10.

The pressure within the etching reaction chamber 10 is monitored by the first pressure meter 11, and the first throttle valve 91 is adjusted, this maintaining a prescribed pressure. As a result, the natural oxide film (silicon oxide) 219 (see FIG. 11) of the silicon structure 81 is etched by the mixed gas.

When the etching completion sensor 97 senses that the mixed gas has completed etching the natural oxide film 219, the eighth valve 35 and the seventh valve 34 are closed, and the mixed methyl alcohol and hydrogen fluoride gas is discharged from the etching reaction chamber 10 via the dry pump 42 and the toxic substance removal device 49.

It is possible in this case also that the data concerning etching periods computed or stored by the control member 502 is utilized, and the etching completion sensor 97 is not utilized.

Next, the first throttle valve 91, the tenth valve 44, the fifth valve 25, the fourth valve 24, and the third valve 23 are opened, the dry pump 42 is started, and pressure is reduced in the etching reaction chamber 10, the sublimated gas storage vessel 21, and the xenon difluoride vessel 20. Since the xenon difluoride is sublimated at a pressure at or below 3.8 Torr, this process sublimates the solid xenon difluoride housed within the xenon difluoride vessel 20. Next, the third valve 23 is closed, and the xenon difluoride gas that has been sublimated in the sublimated gas storage vessel 21 and the etching reaction chamber 10 is discharged. By this means, gas etc. that remains within the sublimated gas storage vessel 21 and the etching reaction chamber 10 is expelled. After discharge, the tenth valve 44, the fifth valve 25, and the fourth valve 24 are closed.

Next, the first throttle valve 91, the tenth valve 44, the fifth valve 25, and the fourth valve 24 are opened, and the dry pump 42 is started, reducing pressure in the etching reaction chamber 10, the sublimated gas storage vessel 21, and the xenon difluoride vessel 20. After pressure has been reduced, the fifth valve 25 is closed and the third valve 23 is opened. In this manner, a state is attained whereby the fifth valve 25 is closed, and the third valve 23 and the fourth valve 24 are open. By this means, the sublimated gas storage vessel 21 and the xenon difluoride vessel 20 are mutually connected in a pressure-reduced state. As a result, the solid xenon difluoride housed within the xenon difluoride vessel 20 is sublimated, and the sublimated xenon difluoride gas is stored within the sublimated gas storage vessel 21. The pressure within the sublimated gas storage vessel 21 is monitored by the second pressure meter 22, and when a prescribed pressure is attained the tenth valve 44 and the third valve 23 are closed, the fifth valve 25 is opened, and the xenon difluoride gas is introduced from the sublimated gas storage vessel 21 into the etching reaction chamber 10. The pressure within the etching reaction chamber 10 is monitored by the first pressure meter 11, and when a prescribed pressure is attained the fifth valve 25 is closed, and the xenon difluoride gas is enclosed within the etching reaction chamber 10. The xenon difluoride gas dry etches the polycrystal silicon layer 208 (see FIG. 11), this constituting the sacrificial layer, of the silicon structure 81 within the etching reaction chamber 10.

When the etching completion sensor 97 senses that the xenon difluoride gas has completed etching the silicon layer 208, the tenth valve 44 is opened, and the xenon difluoride gas is discharged from the etching reaction chamber 10 via the dry pump 42 and the toxic substance removal device 49. After discharge, the fourth valve 24 and the fifth valve 25 are again opened, and the xenon difluoride gas is supplied into the etching reaction chamber 10.

However, it is possible in this case also that the data concerning etching periods computed or stored by the control member 502 is utilized, and the etching completion sensor 97 is not utilized.

In the present embodiment, the polycrystal silicon layer 208 (sacrificial layer) can be etched by the method termed pulse etching, whereby the actions of supplying the xenon difluoride gas into the etching reaction chamber 10, maintaining it therein, and discharging it therefrom are repeated. However, a method is equally possible whereby the gas is supplied continuously while being monitored by the first flow meter 27, and etching is performed continuously. The use of the pulse etching method allows a lesser quantity of xenon difluoride gas to be utilized.

In the first structure manufacturing device described above wet etching so as to remove silicon oxide does not need to be performed. Consequently, there is no need to perform the processes of washing away the etching fluid applied to the silicon structure, and drying the silicon structure following this washing. As a result, the manufacturing process for the silicon structure is simpler.

Furthermore, since wet etching so as to remove silicon oxide does not need to be performed, there is a greatly decreased likelihood of the sticking phenomenon occurring during manufacturing. As a result, the number of defective articles created during manufacturing can be reduced. Put differently, the rigidity and the size of the structure can be reduced compared to the case where wet etching is performed. As a result, structures can be produced that function as highly sensitive or highly accurate sensors, actuators, etc.

Moreover, the silicon and the silicon oxide can be dry etched in the same etching reaction chamber 10 (see FIG. 1). As a result, there is no need for the troublesome action of transferring the silicon structure between the etching reaction chamber of the silicon dry etching device and the etching reaction chamber of the silicon oxide dry etching device. Consequently, the manufacturing process is simpler. Since there is no need to transfer the silicon structure between the etching reaction chambers, the silicon structure need not be exposed to the outside air while being transferred. As a result, a reduction is possible in the number of defective articles produced during manufacture of the silicon structure, or in the number of faulty articles becoming apparent during use. In particular, the problem is prevented in which another natural oxide film forms on the surface face of the silicon after dry etching has been performed on the natural oxide film.

The xenon difluoride gas and the mixed methyl alcohol and hydrogen fluoride gas barely etch aluminum material. Consequently, the aluminum layer 216 (shown in FIG. 9) can be formed before these gases are used to etch the silicon oxide layer 219 that is the natural oxide film and the silicon layer 208 that comprises the sacrificial layer (see FIG. 11). As a result, the aluminum 216 can be prevented from entering the hollow space 220 (shown in FIG. 12) formed after the silicon layer 208 is removed by dry etching. Consequently, a reduction is possible in the number of defective articles produced during manufacture, or in the number of faulty articles becoming apparent during use.

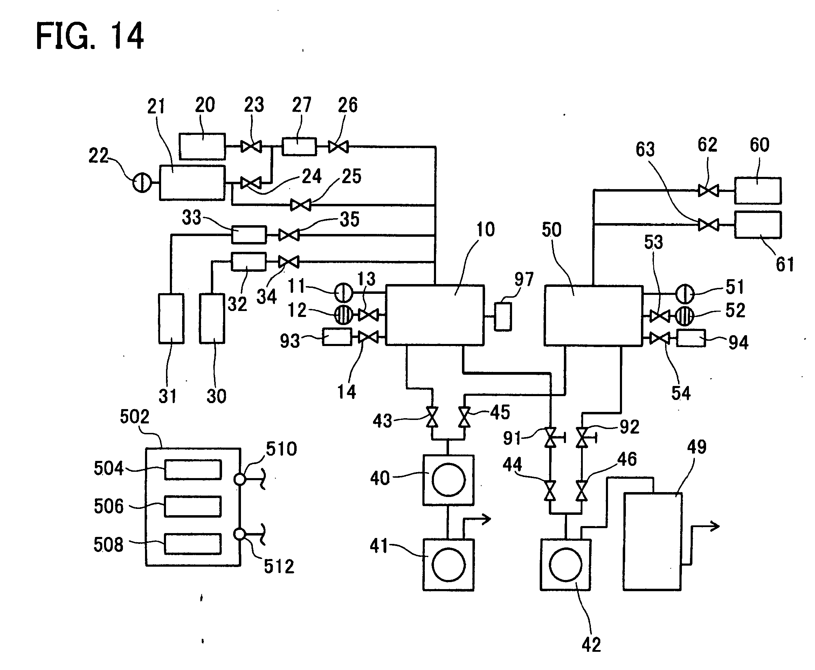

FIG. 14 shows a structure of a second device for manufacturing a silicon structure according to the claimed method. Descriptions are generally omitted below when content is identical with the first device.

The second structure manufacturing device has the configurational elements of the first structure manufacturing device, and in addition thereto is provided with a coating chamber 50, an organosilicic compound vessel 60, a water vessel 61, etc.

Liquid organosilicic compound is housed within the organosilicic compound vessel 60. The liquid organosilicic compound may utilize, for example, tridecafluoro-1, 1, 2, 2, - tetrahydrooctyl trichlorosilane ($C_8F_{13}H_4SiCl_3$), octadecyl trichlorosilane ($C_{18}H_{37}SiCl_3$), etc. Water ($H_2O$) is housed within the water vessel 61.

A third pressure meter 51 is connected with the coating chamber 50. A second vacuum meter 52 is connected with the coating chamber 50 via an eleventh valve 53. A nitrogen gas supply member 94 is connected with the coating chamber 50 via a twelfth valve 54.

The coating chamber 50 is connected with the organosilicic compound vessel 60 via a thirteenth valve 62. The coating chamber 50 is connected with the water vessel 61 via a fourteenth valve 63. The coating chamber 50 is connected with a turbo-molecular pump 40 via a fifteenth valve 45. The coating chamber 50 is connected with a dry pump 42 via a throttle valve 92 and a sixteenth valve 46.

A control member 502 is electrically connected with the valves 45, 46, 53, 54, 62 to 63, and 91, the third pressure meter 51, the second vacuum meter 52, etc. The function of the control member 502 is to monitor and control the action of these members. After the second structure manufacturing device has performed the same actions as the first structure manufacturing device, the following processes are performed.

First, the twelfth valve 54 is opened, nitrogen gas is supplied into the coating chamber 50 from the nitrogen gas supply member 94, and atmospheric pressure is established within the coating chamber 50. Next, a silicon structure is moved from the etching reaction chamber 10 to the coating chamber 50 and the silicon structure is fixed on a silicon structure table of the coating chamber 50. The silicon structure, in detail, is a silicon structure as shown in FIG. 6, wherein dry etching has been completed and the silicon structure is in a state whereby it has a silicon beam or mass structure A. Alternatively, the silicon structure is a silicon structure as shown in FIG. 12, wherein dry etching has been completed and an etching hole 218 thereof is in an as yet unsealed state. The configuration within the coating chamber 50 is approximately the same as the configuration within the etching reaction chamber 10 shown in FIG. 2.

Next, the twelfth valve 54 is closed, the fourteenth valve 63 is opened, the water in the water vessel 61 is volatilized and is introduced into the coating chamber 50, and a surface face of the structure comes into contact with the water vapor. Next, the thirteenth valve 62 is opened, the organosilicic compound within the organosilicic compound vessel 60 is volatilized and is introduced into the coating chamber 50, and the surface face of the structure comes into contact with the organosilicic compound gas. By this means, the surface face of the structure comes into contact with a mixed gas consisting of water vapor and organosilicic compound. As a result, a condensation reaction occurs between the hydroxyl group and a reactive group of the organosilicic compound, thereby coating the surface face of the structure with a water-repellent coating.

Details of the water-repellent coating process described above, and developed by the present inventors, are set forth in Japanese Laid Open Paten Publication TOKKAI 11-288929.

The second structure manufacturing device has the effects set forth in the description of the first structure manufacturing device, and in addition thereto effectively prevents the sticking phenomenon from occurring while the silicon structure is being used. A water-repellent film can be coated onto the surface face of the silicon structure of the present structure manufacturing device. By this means, the silicon structure becomes more water repellent. Consequently, this prevents the problem of liquid adhering to the structure and the surface tension thereof causing the sticking phenomenon to occur even if the structure is being utilized in, for example, surroundings in which dew condensation readily occurs. As a result, a reduced number of defective articles become apparent during use.

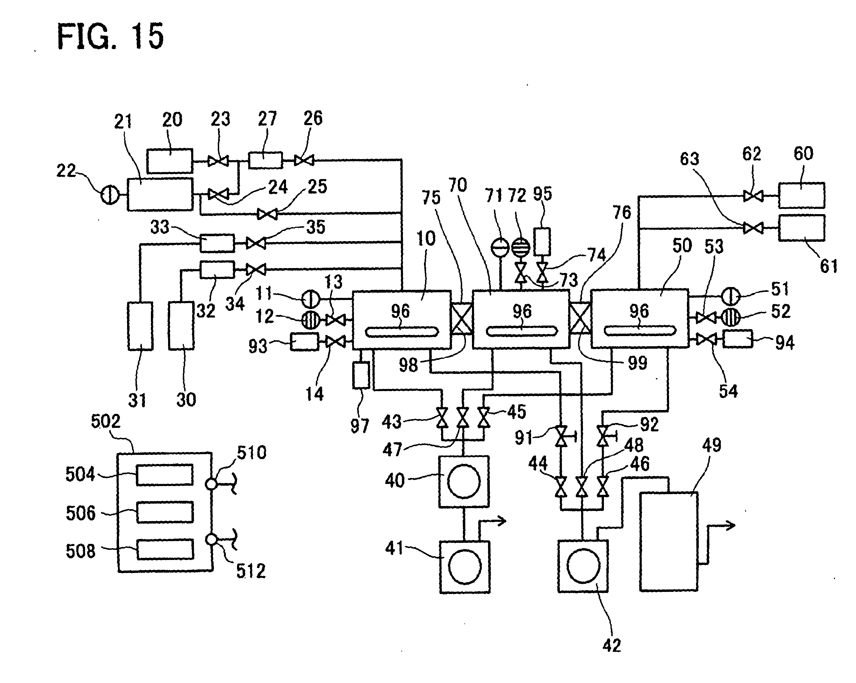

FIG. 15 shows a configuration of a third device for manufacturing a silicon structure according to the claimed method. Descriptions are generally omitted below when content is identical with the first and second device.

The third structure manufacturing device has the configurational elements of the second structure manufacturing device, and in addition thereto is provided with a preparatory chamber 70, first and second connecting members 75 and 76, first and second opening and closing means 98 and 99, a silicon structure conveying means 96, etc.

The first connecting member 75 connects the etching reaction chamber 10 with the preparatory chamber 70 in a manner whereby space therebetween is isolated from the outside air. The second connecting member 76 connects the preparatory chamber 70 with a coating chamber 50 in a manner whereby space therebetween is isolated from the outside air.

The first opening and closing means 98 is capable of switching the space between the etching reaction chamber 10 and the preparatory chamber 70 between an open state and a closed state. The second opening and closing means 99 is capable of switching the space between the preparatory chamber 70 and the coating chamber 50 between an open state and a closed state.

The silicon structure conveying means 96 is capable of conveying a silicon structure between the etching reaction chamber 10 and the preparatory chamber 70, and between the preparatory chamber 70 and the coating chamber 50.

A fourth pressure meter 71 is connected with the preparatory chamber 70. A third vacuum meter 72 is connected with the preparatory chamber 70 via a seventeenth valve 73. A nitrogen gas supply member 95 is connected with the preparatory chamber 70 via an eighteenth valve 74.

The preparatory chamber 70 is connected with a turbo-molecular pump 40 via a nineteenth valve 47. The preparatory chamber 70 is connected with a dry pump 42 via a twentieth valve 48.

After the third structure manufacturing device has performed the same actions as the first structure manufacturing device, the following processes are performed.

First, the nineteenth valve 47 is opened and the turbo-molecular pump 40 and a rotary pump 41 create a vacuum within the preparatory chamber 70. The pressure within the preparatory chamber 70 is monitored by the fourth pressure meter 71, and when a prescribed pressure is attained the silicon structure conveying means 96 moves the silicon structure along the first connecting member 75 from the etching reaction chamber 10 to the preparatory chamber 70. After a prescribed period, the silicon structure conveying means 96 moves the silicon structure along the second connecting member 76, from the preparatory chamber 70 to the coating chamber 50. Then processing is performed of the type described for the second structure manufacturing device (see FIG. 14).

The third structure manufacturing device has the effects set forth in the description of the first and second device. In addition thereto the following effect can be obtained. After dry etching of the silicon structure has been completed in the etching reaction chamber 10, the silicon structure can be conveyed to the coating chamber 50 without its coming into contact with the outside air, thus preventing the silicon structure from being oxidized etc. Further, the provision of the preparatory chamber 70 allows the silicon structure to be transferred easily between the etching reaction chamber 10 and the coating chamber 50.

The embodiments of the method according to the present invention described above merely illustrate some of the possibilities of the present invention and do not restrict the scope of the claims. The art set forth in the claims encompasses various transformations and modifications to the embodiments described above.

In the above embodiments, example descriptions were given of manufacturing methods for the hollow silicon structure having the diaphragm B configuration shown in FIG. 13. However, this structure merely illustrate a structure capable of being manufactured by the method according to the present invention performed in the described structure manufacturing devices. The method of the present invention is suitable for the manufacture of a variety of structures that include at least silicon and silicon oxide in their manufacture.

Further, instead of the xenon difluoride ($XeF_2$) gas utilized in the present embodiments, brominetrifluoride ($BrF_3$) gas may also be utilized.

Further, instead of the mixed gas of methyl alcohol ($CH_3OH$) and hydrogen fluoride (HF) utilized in the present embodiments, a mixed gas of water vapor ($H_2O$) and hydrogen fluoride (HF) may also be utilized. Further, instead of utilizing methyl alcohol and water vapor, a gas may instead be utilized that forms $HF_2$ when mixed with hydrogen fluoride (HF).

In addition to the gases mentioned above, any other gas may of course be utilized as long as the gas fulfills the requirements of the claims.

Furthermore, the configuration of FIG. 3, the purpose of which is, for example, to prevent methyl alcohol solution that has boiled up within the methyl alcohol vessel 31 from blocking the piping, can instead be embodied in the following manners.

(FIRST VARIATION)

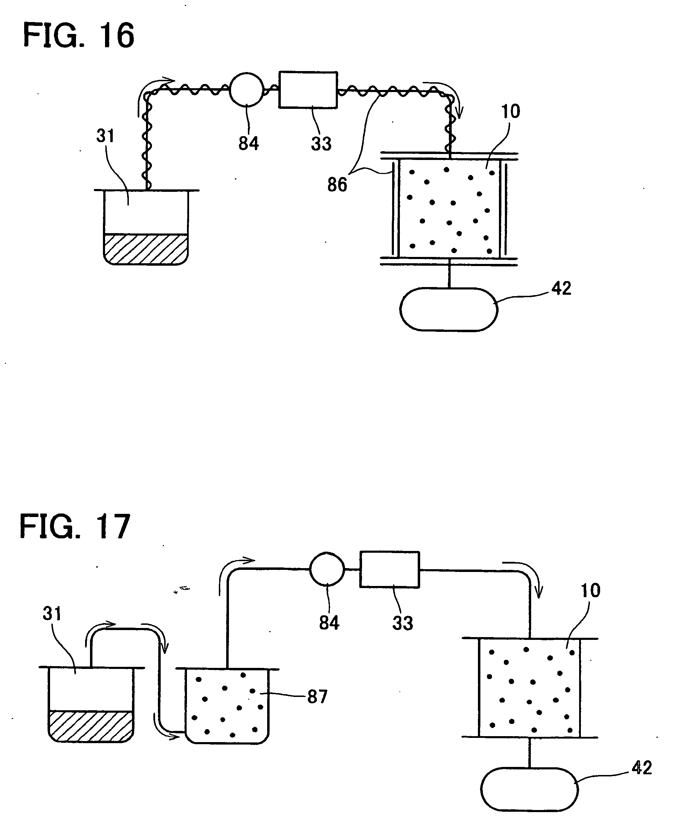

As shown in FIG. 16, a cord heater 86 may be attached to the piping and the etching reaction chamber 10, this heating the piping and the etching reaction chamber 10 and thereby gasifying the liquid that has entered the piping from the methyl alcohol vessel 31 as a result of boiling up.

(SECOND VARIATION)

As shown in FIG. 17, a reserve tank 87 may be provided between the methyl alcohol vessel 31 and the filter 84, the methyl alcohol being entirely gasified within the reserve tank 87, and then the gas being supplied to the etching reaction chamber 10.

(THIRD VARIATION)

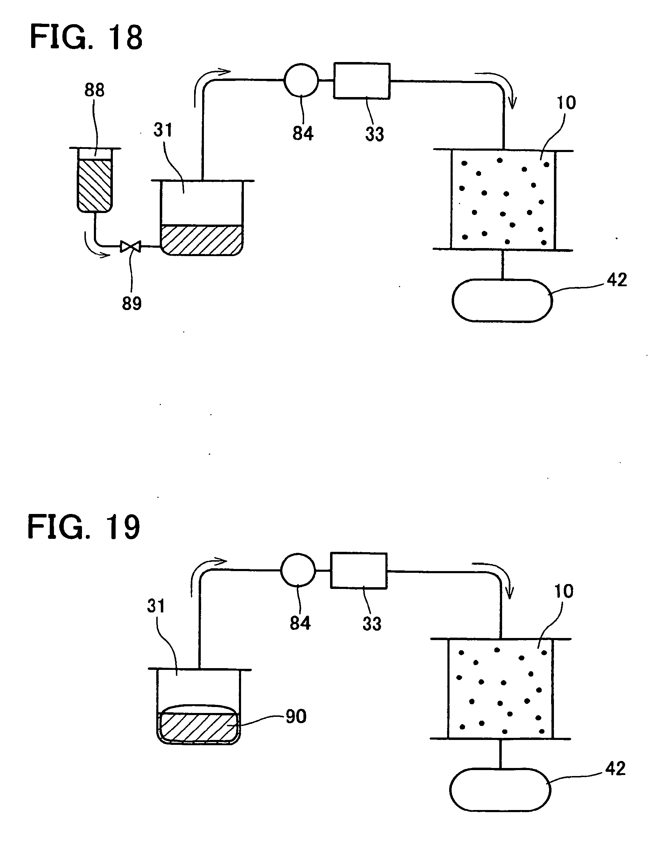

As shown in FIG. 18, a reserve vessel 88 and a control valve 89 may be provided in front of the methyl alcohol vessel 31, additional methyl alcohol being supplied thereto from the reserve vessel 88 in accordance with the volatilization rate of the liquid within the methyl alcohol vessel 31, the flow rate of the raw material from the reserve vessel 88 being regulated by the control valve 89.

(FOURTH VARIATION)

As shown in FIG. 19, the liquid within the methyl alcohol vessel 31 has a sponge or fibers 90, or the like immersed therein, this preventing the surface face of liquid from boiling up and thus preventing the liquid from boiling up when the dry pump 42 performs evacuation.

Furthermore, the art disclosed in the present specification or figures may be utilized to simultaneously realize a plurality of aims or to realize one of these aims.

**Claims**

1.  A method of forming a hollow structure from a silicon structure having a lower silicon nitride layer (210), a polycrystalline silicon layer (208) formed on the lower silicon nitride layer (210) and an upper silicon nitride layer (212, 214) formed above the polycrystalline silicon layer (208), the method comprising:

etching through the upper silicon nitride layer, thereby exposing a portion of the polycrystalline silicon layer then performing the method in a device, the device comprising a first gas supply member (20, 30, 31), a second gas supply member (20, 30, 31), an etching reaction chamber (10) for performing gas etching, a selective connecting means (23, 24, 25, 26, 34, 35), and a gas discharging means (40, 41, 42), comprising the steps of etching natural silicon oxide (219) formed on the exposed portion of the polycrystalline silicon layer (208) using a first gas capable of etching silicon oxide and barely capable of etching the silicon nitride (210, 214), thereby exposing the polycrystalline silicon layer (208),

etching the exposed polycrystalline silicon layer (208) using a second gas capable of etching the silicon and barely capable of etching the silicon nitride (210, 212, 214), thereby forming the hollow structure, wherein the selective connecting means (23, 24, 25, 26, 34, 35) connects the etching reaction chamber (10) with selectively either the first gas supply member (20, 30, 31) or the second gas supply member (20, 30, 31), and the gas discharging means (40, 41, 42) discharges the gas from the etching reaction chamber (10), wherein the gas discharging means (40, 41, 42) comprises a rapid discharging means (40, 41) and a slow discharging means (42).

2. The method according to claim 1, wherein the device further comprises
a vessel (60) for storing an organosilicic compound, a vessel (61) for storing water, a gas transforming means, a coating chamber (50), a connecting member (75, 76), an opening and closing means (98, 99), and a silicon structure conveying means (96), wherein
the gas transforming means transforms the organosilicic compound within the vessel (60) for storing an organosilicic compound and water within the vessel (61) for storing water into gas,
the coating chamber (50) introduces the gas transformed by the gas transforming means (40, 41, 42),
the connecting member (75, 76) connects the etching reaction chamber (10) with the coating chamber (50) in a manner that a space between the etching reaction chamber (10) and the coating chamber (50) is isolated from the outside,
the opening and closing means (98, 99) is capable of switching a connection between the etching reaction chamber (10) and the coating chamber (50) between an open state and a closed state, and
the silicon structure conveying means (96) is capable of conveying the silicon structure between the etching reaction chamber (10) and the coating chamber (50).

3. The method according to claim 2, wherein the gas discharging means (40, 41, 42) comprise pumps (40, 41, 42).

4. The method according to claim 2 or 3, wherein the device further comprises a preparatory chamber (70), wherein the connecting member (75, 76) connects the etching reaction chamber (10) with the preparatory chamber (70) and connects the preparatory chamber (70) with the coating chamber (50) in a manner that the spaces between the chambers (10, 70, 50) are isolated from the outside,
the opening and closing means (98, 99) is capable of switching a connection between the etching reaction chamber (10) and the preparatory chamber (70), and a connection between the preparatory chamber (70) and the coating chamber (50), between an open state and a closed state, and
the silicon structure conveying means (96) is capable of conveying the silicon structure between the etching reaction chamber (10) and the preparatory chamber (70), and between the preparatory chamber (70) and the coating chamber (50).

**Patentansprüche**

1. Verfahren zum Bilden einer hohlen Struktur aus einer Siliziumstruktur, die eine untere Siliziumnitridschicht (210), eine polykristalline Siliziumschicht (208), die auf der unteren Siliziumnitridschicht (210) ausgebildet ist, und eine obere Siliziumnitridschicht (212, 214), die auf der polykristallinen Siliziumschicht (208) ausgebildet ist, aufweist, wobei das Verfahren umfasst:

Ätzen durch die obere Siliziumnitridschicht, wodurch ein Teil der polykristallinen Siliziumschicht freigelegt wird, dann Durchführen des Verfahrens in einer Vorrichtung, wobei die Vorrichtung ein erstes Gaszuführelement (20, 30, 31), ein zweites Gaszuführelement (20, 30, 31), eine Ätzreaktionskammer (10) zum Durchführen eines Gasätzens, ein selektives Verbindungsmittel (23, 24, 25, 26, 34, 35) und ein Gasaustragmittel (40, 41, 42) umfasst, umfassend die Schritte des
Ätzens von natürlichem Siliziumoxid (219), das auf dem freigelegten Teil der polykristallinen Siliziumschicht (208) ausgebildet ist, unter Verwendung eines ersten Gases, das Siliziumoxid ätzen kann und das Siliziumnitrid (210, 214) kaum ätzen kann, wodurch die polykristalline Siliziumschicht (208) freigelegt wird,

Ätzen der freigelegten polykristallinen Siliziumschicht (208) unter Verwendung eines zweiten Gases, welches das Silizium ätzen kann und das Siliziumnitrid (210, 212, 214) kaum ätzen kann, wodurch die hohle Struktur gebildet wird, wobei

das selektive Verbindungsmittel (23, 24, 25, 26, 34, 35) die Ätzreaktionskammer (10) selektiv entweder mit dem ersten Gaszuführelement (20, 30, 31) oder dem zweiten Gaszuführelement (20, 30, 31) verbindet, und

das Gasaustragmittel (40, 41, 42) das Gas aus der Ätzreaktionskammer (10) austrägt, wobei das Gasaustragmittel (40, 41, 42) ein schnelles Austragmittel (40, 41) und ein langsames Austragmittel (42) umfasst.

2. Verfahren nach Anspruch 1, wobei die Vorrichtung ferner

einen Behälter (60) zum Lagern einer Organosiliziumverbindung, einen Behälter (61) zum Lagern von Wasser, ein Gasumwandlungsmittel, eine Beschichtungskammer (50), ein Verbindungselement (75, 76), ein Öffnungs- und Schließmittel (98, 99) und ein Siliziumstruktur-Fördermittel (96) umfasst, wobei

das Gasumwandlungsmittel die Organosiliziumverbindung innerhalb des Behälters (60) zum Lagern einer Organosiliziumverbindung und Wasser innerhalb des Behälters (61) zum Lagern von Wasser in Gas umwandelt,

die Beschichtungskammer (50) das durch das Gasumwandlungsmittel (40, 41, 42) umgewandelte Gas einführt,

das Verbindungselement (75, 76) die Ätzreaktionskammer (10) mit der Beschichtungskammer (50) in einer Weise verbindet, dass ein Raum zwischen der Ätzreaktionskammer (10) und der Beschichtungskammer (50) von der äußeren Umgebung isoliert ist,

das Öffnungs- und Schließmittel (98, 99) eine Verbindung zwischen der Ätzreaktionskammer (10) und der Beschichtungskammer (50) zwischen einem offenen Zustand und einem geschlossenen Zustand umschalten kann, und

das Siliziumstruktur-Fördermittel (96) die Siliziumstruktur zwischen der Ätzreaktionskammer (10) und der Beschichtungskammer (50) fördern kann.

3. Verfahren nach Anspruch 2, wobei das Gasaustragmittel (40, 41, 42) Pumpen (40, 41, 42) umfasst.

4. Verfahren nach Anspruch 2 oder 3, wobei die Vorrichtung ferner eine Vorbereitungskammer (70) umfasst, wobei das Verbindungselement (75, 76) die Ätzreaktionskammer (10) mit der Vorbereitungskammer (70) verbindet und die Vorbereitungskammer (70) mit der Beschichtungskammer (50) verbindet, in einer Weise, dass die Räume zwischen den Kammern (10, 70, 50) von der äußeren Umgebung isoliert sind,

das Öffnungs- und Schließmittel (98, 99) eine Verbindung zwischen der Ätzreaktionskammer (10) und der Vorbereitungskammer (70) und eine Verbindung zwischen der Vorbereitungskammer (70) und der Beschichtungskammer (50) zwischen einem offenen Zustand und einem geschlossenen Zustand umschalten kann, und

das Siliziumstruktur-Fördermittel (96) die Siliziumstruktur zwischen der Ätzreaktionskammer (10) und der Vorbereitungskammer (70) und zwischen der Vorbereitungskammer (70) und der Beschichtungskammer (50) fördern kann.

## Revendications

1. Procédé de formation d'une structure creuse à partir d'une structure de silicium ayant une couche inférieure de nitrure de silicium (210), une couche de silicium polycristallin (208) formée sur la couche inférieure de nitrure de silicium (210) et une couche supérieure de nitrure de silicium (212, 214) formée par-dessus la couche de silicium polycristallin (208), le procédé comprenant les étapes consistant à :

graver la couche supérieure de nitrure de silicium, exposant de la sorte une partie de la couche de silicium polycristallin,

puis mettre en oeuvre le procédé dans un dispositif, le dispositif comprenant un premier élément d'alimentation en gaz (20, 30, 31), un second élément d'alimentation en gaz (20, 30, 31), une chambre réactionnelle de gravure (10) pour effectuer une gravure par un gaz, un moyen de raccordement sélectif (23, 24, 25, 26, 34, 35) et un moyen de décharge de gaz (40, 41, 42), comprenant les étapes consistant à :

graver l'oxyde de silicium naturel (219) formé sur la partie exposée de la couche de silicium polycristallin (208) en utilisant un premier gaz capable de graver l'oxyde de silicium et tout juste capable de graver le nitrure de silicium (210, 214), exposant de la sorte la couche de silicium polycristallin (208),

graver la couche exposée de silicium polycristallin (208) en utilisant un second gaz capable de graver le silicium et tout juste capable de graver le nitrure de silicium (210, 212, 214), formant de la sorte la structure creuse, dans lequel :

le moyen de raccordement sélectif (23, 24, 25, 26, 34, 35) raccorde la chambre réactionnelle de gravure (10) avec sélectivement soit le premier élément d'alimentation en gaz (20, 30, 31), soit le second élément d'alimentation en gaz (20, 30, 31), et

le moyen de décharge de gaz (40, 41, 42) décharge le gaz provenant de la chambre réactionnelle de gravure (10), dans lequel le moyen de décharge de gaz (40, 41, 42) comprend un moyen de décharge rapide (40, 41) et un moyen de décharge lent (42).

2.  Procédé selon la revendication 1, dans lequel le dispositif comprend en outre :

une cuve (60) pour stocker un composé d'organosilicium, une cuve (61) pour stocker de l'eau, un moyen de transformation de gaz, une chambre de revêtement (50), un élément de raccordement (75, 76), un moyen d'ouverture et de fermeture (98, 99) et un moyen (96) de transport de la structure de silicium, dans lequel :

le moyen de transformation de gaz transforme le composé d'organosilicium qui se trouve à l'intérieur de la cuve (60) pour stocker un composé d'organosilicium et de l'eau à l'intérieur de la cuve (61) afin de stocker de l'eau dans le gaz,

la chambre de revêtement (50) introduit le gaz transformé par le moyen de transformation de gaz (40, 41, 42), l'élément de raccordement (75, 76) raccorde la chambre réactionnelle de gravure (10) à la chambre de revêtement (50) de sorte qu'un espace entre la chambre réactionnelle de gravure (10) et la chambre de revêtement (50) soit isolé de l'extérieur,

le moyen d'ouverture et de fermeture (98, 99) est capable de commuter un raccordement entre la chambre réactionnelle de gravure (10) et la chambre de revêtement (50) entre un état ouvert et un état fermé, et

le moyen (96) de transport de la structure de silicium est capable de transporter la structure de silicium entre la chambre réactionnelle de gravure (10) et la chambre de revêtement (50).

3.  Procédé selon la revendication 2, dans lequel le moyen de décharge de gaz (40, 41, 42) comprend des pompes (40, 41, 42).

4.  Procédé selon la revendication 2 ou 3, dans lequel le dispositif comprend en outre une chambre préparatoire (70), dans laquelle :

l'élément de raccordement (75, 76) raccorde la chambre réactionnelle de gravure (10) à la chambre préparatoire (70) et raccorde la chambre préparatoire (70) à la chambre de revêtement (50) de sorte que les espaces entre les chambres (10, 70, 50) soient isolés de l'extérieur,

le moyen d'ouverture et de fermeture (98, 99) est capable de commuter un raccordement entre la chambre réactionnelle de gravure (10) et la chambre préparatoire (70) et un raccordement entre la chambre préparatoire (70) et la chambre de revêtement (50), entre un état ouvert et un état fermé, et

le moyen (96) de transport de la structure de silicium est capable de transporter la structure de silicium entre la chambre réactionnelle de gravure (10) et la chambre préparatoire (70), et entre la chambre préparatoire (70) et la chambre de revêtement (50).

# FIG. 1

EP 1 382 565 B1

**FIG. 2**

**FIG. 3**

# FIG. 4

112

102

108

# FIG. 5

118

112

102

108

# FIG. 6

118

A

112

102

120

FIG. 7

FIG. 8

FIG. 9

## FIG. 10

216b        206     216a

214
212
210

204    208

202

## FIG. 11

216b   219   218      206     216a

214
212
210

204    208

202

## FIG. 12

## FIG. 13

# FIG. 14

EP 1 382 565 B1

# FIG. 15

EP 1 382 565 B1

# FIG. 16

# FIG. 17

EP 1 382 565 B1

FIG. 18

FIG. 19

29

# FIG. 20

312
302
308

# FIG. 21

318
312
302
308

# FIG. 22

318
A
312
302
320

# FIG. 23

# FIG. 24

## FIG. 25

## FIG. 26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5013398 A
- US 5286344 A
- JP 10209088 A
- JP TOKKAIHEI8116070 B
- JP TOKKAIHEI496222 B
- JP TOKKAI2001185530 B
- JP TOKKAI11288929 B